# EUROPEAN PATENT SPECIFICATION

(11) **EP 4 254 701 B1**
(45) Date of publication and mention of the grant of the patent: **25.03.2026**
(21) Application number: 22762461.6
(22) Date of filing: 28.02.2022
(51) Int. Cl.: H02H 7/26

(54) **MULTIPORT HYBRID DIRECT-CURRENT CIRCUIT BREAKER, APPARATUS, SYSTEM, AND CONTROL METHOD THEREFOR**
HYBRIDER MULTIPORT-GLEICHSTROMSCHUTZSCHALTER, VORRICHTUNG, SYSTEM UND STEUERUNGSVERFAHREN DAFÜR
DISJONCTEUR À COURANT CONTINU HYBRIDE MULTIPORT, APPAREIL, SYSTÈME ET PROCÉDÉ DE COMMANDE ASSOCIÉS

(30) Priority: 03.03.2021 CN 202110234171
(43) Date of publication of application: 04.10.2023
(73) Proprietor: NR ELECTRIC CO., LTD., Jiangning Nanjing, Jiangsu 211102 (CN); NR Engineering Co., Ltd., Nanjing, Jiangsu 211102 (CN); NR Electric Power Electronics Co., Ltd., Changzhou, Jiangsu 213025 (CN)
(72) Inventor: SHI, Wei, Nanjing, Jiangsu 211102 (CN); CAO, Dongming, deceased (CN); FANG, Taixun, Nanjing, Jiangsu 211102 (CN); XIE, Yeyuan, Nanjing, Jiangsu 211102 (CN); YANG, Bing, Nanjing, Jiangsu 211102 (CN); LV, Wei, Nanjing, Jiangsu 211102 (CN); WANG, Wenjie, Nanjing, Jiangsu 211102 (CN); XU, Yuanzhen, Nanjing, Jiangsu 211102 (CN); CHEN, Yu, Nanjing, Jiangsu 211102 (CN); SUN, Chao, Nanjing, Jiangsu 211102 (CN)
(74) Representative: Grünecker Patent- und Rechtsanwälte PartG mbB
(86) International application number: PCT/CN2022/078134
(87) International publication number: WO 2022/183996

(56) References cited:
- EP-A1- 3 540 750
- WO-A1-2013/093066
- WO-A1-2020/191847
- CN-A- 109 193 580
- CN-A- 109 193 625
- CN-A- 110 048 377
- CN-A- 111 509 663
- CN-B- 110 048 377
- JP-A- 2018 036 054
- US-A1- 2022 006 286

## Description

### CROSS-REFERENCE TO RELATED APPLICATIONS

This application claims priority to Chinese Patent Application No. 202110234171.0, entitled "MULTI-PORT HYBRID DIRECT CURRENT CIRCUIT BREAKER AND CONTROL METHOD THEREOF" filed with the Chinese Patent Office on March 03, 2021.

### TECHNICAL FIELD

This application relates to the technical field of direct current power grids, and particularly relates to a multi-port hybrid direct current circuit breaker, apparatus and system and a control method thereof.

### BACKGROUND

With the trend of complexity of a direct current power grid structure, the number of direct current circuit breakers to be additionally arranged in a direct current power grid system is greatly increased. The high investment of the direct current circuit breakers has become a bottleneck problem restricting the development of direct current power grids. Because the cost of breaking switches formed by connecting a large number of power electronic devices in series and parallel is the main cost of the direct current circuit breakers, a design idea of a multi-port direct current circuit breaker has been proposed in recent years, that is, all incoming and outgoing lines on a same direct current bus share an expensive breaking switch. Therefore, by adopting the multi-port direct current circuit breaker, the number and the input cost of the direct current circuit breakers in the direct current power grids can be greatly reduced while the fault current breaking capacity of each incoming and outgoing line can be guaranteed.

EP 3 540 750 A1 relates to a HVDC circuit breaker, HVDC switchyard, HVDC switchyard system, and HVDC grid. The HVDC circuit breaker comprises three or more terminals and, for each group of two of the terminals, a respective inter-terminal connection branch between the terminals. The inter-terminal connection branches each comprise at least one commutation switch arrangement.

CN 110048377 B relates to a multi-port hybrid DC circuit breaker and control method suitable for DC distribution network. A multi-port hybrid DC circuit breaker for a DC distribution network comprises: a main branch, a transfer branch and an energy consumption branch connected in parallel; the main branch comprises: a plurality of main branch units connected in parallel, each main branch unit is connected between a DC bus and its outgoing line; each main branch unit comprises: an isolating switch, a fast mechanical switch and a load transfer switch connected in series in sequence; the isolating switch is connected to the outgoing line of the DC bus, and the load transfer switch is connected to the DC bus; each main branch unit is connected to the transfer branch through a diode, and the DC bus is connected to the transfer branch through a diode.

WO 2013/093066 A1 relates to hybrid DC circuit breaking device. The electronic breaker switch comprises a solid state semiconductor based circuit breaker or a vacuum tube circuit breaker capable of interrupting current either in only one direction or in both directions.

WO 2020/191847 A1 relates to an annular bridge-type multi-port hybrid direct-current circuit breaker. The circuit breaker comprises: an upper direct-current bus, a lower direct-current bus, n thyristor bridge arms, n diode bridge arms, a main current-breaking branch, and n bypass branches; each thyristor bridge arm is connected in series with one diode bridge arm to form a series circuit, the series circuits are all connected in parallel to the main current-breaking branch to form a parallel circuit, one end of the parallel circuit is connected to the upper direct-current bus, and the other end is connected to the lower direct-current bus, each bypass branch is connected between every two adjacent series-connected circuits, one port is connected at a connection point of the thyristor bridge arm and the diode bridge arm in each series circuit.

### SUMMARY

It is the object of the present invention to improve a protection level of a multi-port hybrid direct current circuit breaker with minimum additional hardware.

This object is solved by the subject matter of the independent claims.

Preferred embodiments are defined by the dependent claims.

Each exemplary embodiment of this application provides a multi-port hybrid direct current circuit breaker. The multi-port hybrid direct current circuit breaker includes at least two through-flow branches, at least two reversing branches and a breaking branch; each of the at least two through-flow branches includes a first fast mechanical switch and a one-way commutation switch which are connected in series; one ends of the at least two through-flow branches are connected with each other to form a direct current bus; the current breaking direction of the one-way commutation switch of each of the at least two through-flow branches is the same; each of the at least two reversing branches includes a diode upper bridge arm and a diode lower bridge arm which are connected in series in the same direction; the other ends of the at least two through-flow branches are correspondingly connected to intermediate points between the diode upper bridge arms and the diode lower bridge arms of the corresponding reversing branches to form ports; the breaking branch includes a one-way breaking switch and a nonlinear resistor which are connected in parallel; the breaking branch and the at least two reversing branches are connected in parallel, and a first common bus and a second common bus are formed at the two ends subj ected to parallel connection respectively; the current breaking direction of the one-way breaking switch of the breaking branch is the direction that the first common bus points to the second common bus; cathodes of the diode upper bridge arms of the reversing branches are connected to the direction of the first common bus; and anodes of the diode lower bridge arms of the reversing branches are connected to the second common bus.

In one embodiment, the multi-port hybrid direct current circuit breaker further includes a bus fault protection branch; the bus fault protection branch includes a second fast mechanical switch; one end of the second fast mechanical switch is connected to the direct current bus, and the other end of the second fast mechanical switch is connected to the first common bus; or one end of the second fast mechanical switch is connected to the direct current bus, and the other end of the second fast mechanical switch is connected to the second common bus.

In one embodiment, the multi-port hybrid direct current circuit breaker further includes a bus fault protection branch; the bus fault protection branch includes a second fast mechanical switch and a one-way conduction switch which are connected in series, two ends of the bus fault protection branch are respectively connected to the first common bus and the second common bus, and an intermediate point between the second fast mechanical switch and the one-way conduction switch of the bus fault protection branch is connected to the direct current bus; one end of the second fast mechanical switch is connected to the first common bus, and one end of the one-way conduction switch is connected to the second common bus; the conduction direction of the one-way conduction switch is the direction that the second common bus points to the direct current bus, and the current breaking directions of the one-way commutation switches of the through-flow branches are the directions pointing to the direct current bus; or
one end of the second fast mechanical switch is connected to the second common bus; one end of the one-way conduction switch is connected to the first common bus; the conduction direction of the one-way conduction switch is the direction that the direct current bus points to the first common bus; and the current breaking directions of the one-way commutation switches of the through-flow branches are the directions pointing to the ports.

In one embodiment, the one-way conduction switch includes at least one diode connected in series, and at least one third switch semiconductor device connected in series, and the at least one diode and the at least one third switch semiconductor device are connected in series.

In one embodiment, the third switch semiconductor device includes at least one of SCR, IGBT, IEGT, IGCT or MOSFET.

In one embodiment, the multi-port hybrid direct current circuit breaker further includes an auxiliary energy consumption branch; the auxiliary energy consumption branch includes a diode group and a linear resistor which are connected in series; when one end of the second fast mechanical switch is connected to the direct current bus, and the other end of the second fast mechanical switch is connected to the first common bus, one end of the auxiliary energy consumption branch is connected to the second common bus, and the other end of the auxiliary energy consumption branch is connected to the ground or a metal loop; a cathode of the diode group is connected to the second common bus; or when one end of the second fast mechanical switch is connected to the direct current bus, and the other end of the second fast mechanical switch is connected to the second common bus, one end of the auxiliary energy consumption branch is connected to the first common bus, and the other end of the auxiliary energy consumption branch is connected to the ground or the metal loop; and an anode of the diode group is connected to the first common bus.

In one embodiment, the diode group includes at least one diode connected in series.

In one embodiment, the first fast mechanical switch includes at least one mechanical switch break connected in series; and/or
the second fast mechanical switch includes at least one mechanical switch break connected in series.

In one embodiment, the one-way commutation switch includes at least one first switch semiconductor device connected in series; and/or the one-way breaking switch includes at least one second switch semiconductor device connected in series.

In one embodiment, the first switch semiconductor device and the second switch semiconductor device include at least one of IGBT, IEGT, IGCT or MOSFET.

In one embodiment, the diode upper bridge arm includes at least one diode connected in series; and the diode lower bridge arm includes at least one diode connected in series.

The embodiment of this application further provides a control method of the multi-port hybrid direct current circuit breaker described above. The control method includes: controlling on/off of the through-flow branches, the reversing branches and the breaking branch based on working modes of the multi-port hybrid direct current circuit breaker, the working modes including a normal operation mode, an opening mode and a closing mode.

In one embodiment, when the multi-port hybrid direct current circuit breaker is in the normal operation mode, each through-flow branch is controlled to be in an on state, and the breaking branch is controlled to be in an off state; and when the multi-port hybrid direct current circuit breaker further includes a bus fault protection branch, the method further includes: controlling the bus fault protection branch to be in an off state when the multi-port hybrid direct current circuit breaker is in the normal operation mode.

In one embodiment, the multi-port hybrid direct current circuit breaker is in the opening mode, and when the port connected to the multi-port hybrid direct current circuit breaker needs to be cut off, the one-way breaking switch of the breaking branch is controlled to be on, the one-way commutation switches of all the through-flow branches are controlled to be off, and current starts to be transferred to the one-way breaking switch of the breaking branch through the reversing branches; when the current of all the through-flow branches is close to zero, the first fast mechanical switch of the through-flow branch in which the port to be cut off is located is controlled to be opened; when the first fast mechanical switch of the through-flow branch in which the port to be cut off is located is opened to an insulation voltage position, the one-way breaking switch of the breaking branch is controlled to be off, the one-way commutation switches of all the through-flow branches are controlled to be on, and the current of the port to be cut off is controlled to be transferred to the nonlinear resistor of the breaking branch and the linear resistor of the auxiliary energy consumption branch; and when the current of the port to be cut off is gradually reduced to zero, the current of other ports except the port to be cut off is recovered to related through-flow branches, the opening is successful, and the opening operation is finished.

In one embodiment, the multi-port hybrid direct current circuit breaker is in the closing mode, and when the port connected to the multi-port hybrid direct current circuit breaker needs to be connected, the one-way breaking switch of the breaking branch is controlled to be on; if the multi-port hybrid direct current circuit breaker is not closed due to a fault, the first fast mechanical switch of the through-flow branch in which the port to be connected is located is controlled to be on; and when the first fast mechanical switch of the through-flow branch in which the port to be connected is located is in a closed position, the one-way breaking switch of the breaking branch is controlled to be off, the closing is successful, and closing operation is finished.

In one embodiment, if the multi-port hybrid direct current circuit breaker is closed due to a fault, the one-way breaking switch of the breaking branch is controlled to be off, the closing fails, and the closing operation is finished.

In one embodiment, when the multi-port hybrid direct current circuit breaker further includes a bus fault protection branch, the working mode further includes a bus fault protection mode; and if the multi-port hybrid direct current circuit breaker is in the bus fault protection mode, the control is carried out based on the fault type. The method further includes: controlling the one-way breaking switch of the breaking branch to be on, controlling the one-way conduction switch of the bus fault protection branch to be on, and controlling the one-way commutation switches of all the through-flow branches to be off when the fault type is a direct current bus grounding fault, and starting to transfer the current to the one-way breaking switch of the breaking branch through the reversing branches; controlling the first fast mechanical switches of all the through-flow branches to be off when the current of all the through-flow branches is close to zero; and controlling the one-way breaking switch of the breaking branch to be off, and controlling the one-way commutation switches of all the through-flow branches to be on when the first fast mechanical switches of all the through-flow branches are opened to the insulation voltage position, and transferring the current to the nonlinear resistor of the breaking branch; and successfully opening, and finishing the opening operation when the current is reduced to zero.

In one embodiment, if the fault type is that the multi-port hybrid direct current circuit breaker is connected to a positive electrode of a direct current power grid system and the first common bus has a grounding fault, the multi-port hybrid direct current circuit breaker cannot implement a bus isolation operation, and the second fast mechanical switch of the bus fault protection branch is controlled to be on to start backup failure protection; if the fault type is that the multi-port hybrid direct current circuit breaker is connected to a negative electrode of the direct current power grid system and the second common bus has a grounding fault, the multi-port hybrid direct current circuit breaker cannot implement the bus isolation operation, and the second fast mechanical switch of the bus fault protection branch is controlled to be on to start backup failure protection; if the fault type is that the multi-port hybrid direct current circuit breaker is connected to the positive electrode of the direct current power grid system and the second common bus has a grounding fault, bus differential protection of the multi-port hybrid direct current circuit breaker in the normal operation mode cannot act, and if the opening operation is carried out at the moment, the bus differential protection can be triggered, and the multi-port hybrid direct current circuit breaker can stop the opening operation and start backup failure protection; and/or if the fault type is that the multi-port hybrid direct current circuit breaker is connected to the negative electrode of the direct current power grid system and the first common bus has a grounding fault, the bus differential protection of the multi-port hybrid direct current circuit breaker in the normal operation mode cannot act, and if the opening operation is carried out at the moment, the bus differential protection can be triggered, and the multi-port hybrid direct current circuit breaker can stop the opening operation and start backup failure protection.

The embodiment of this application further provides a fault protection apparatus of a direct current power grid system applying the control method of the multi-port hybrid direct current circuit breaker described above. The fault protection apparatus includes the multi-port hybrid direct current circuit breaker.

The embodiment of this application further provides a direct current power grid system applying the control method of the multi-port hybrid direct current circuit breaker described above. The direct current power grid system includes the above fault protection apparatus.

According to the technical solution in the embodiment of this application, the fault protection of a plurality of power transmission lines can be achieved by sharing an expensive breaking switch, and the more the power transmission lines are, the better the economic efficiency is; compared with an existing two-port or multi-port hybrid direct current circuit breaker, the number of semiconductors of a current flowing path is halved, the through-flow loss is reduced, and the economic efficiency is improved; the bus fault protection capacity is achieved, and the reliability of the direct current circuit breaker is improved; the auxiliary energy consumption capacity is achieved, auxiliary energy consumption is carried out through the high-reliability linear resistor, and therefore the requirement for nonlinear resistor energy is reduced, and the reliability of the direct current circuit breaker is improved; rapid on/off of rated current, rapid on/off of fault current and rapid reclosing of the hybrid direct current circuit breaker are kept.

### BRIEF DESCRIPTION OF THE DRAWINGS

In order to explain the technical solutions in the embodiments of this application more clearly, the accompanying drawings needed in the description of the embodiments will be briefly introduced below. Obviously, the accompanying drawings in the following description are only some embodiments of the application. For a person of ordinary skill in the art, other drawings can be obtained according to these accompanying drawings without creative efforts.
FIG. 1 is a topological graph of a multi-port hybrid direct current circuit breaker according to an embodiment of this application.
FIG. 2 is a topological graph of a multi-port hybrid direct current circuit breaker connected to a positive electrode of a direct current power grid system through a bus fault protection branch according to an embodiment of this application.
FIG. 3 is a topological graph of a multi-port hybrid direct current circuit breaker connected to a negative electrode of a direct current power grid system through a bus fault protection branch according to an embodiment of this application.
FIG. 4 is a third topological graph of a multi-port hybrid direct current circuit breaker connected to a positive electrode of a direct current power grid system through a bus fault protection branch according to an embodiment of this application.
FIG. 5 is a topological graph of a multi-port hybrid direct current circuit breaker connected to a negative electrode of a direct current power grid system through a bus fault protection branch according to an embodiment of this application.
FIG. 6 is a topological graph of a multi-port hybrid direct current circuit breaker provided with an auxiliary energy consumption branch and connected to a positive electrode of a direct current power grid system according to an embodiment of this application.
FIG. 7 is a topological graph of a multi-port hybrid direct current circuit breaker provided with an auxiliary energy consumption branch and connected to a negative electrode of a direct current power grid system according to an embodiment of this application.
FIG. 8 is a topological graph of a multi-port hybrid direct current circuit breaker provided with an auxiliary energy consumption branch and connected to a positive electrode of a direct current power grid system through a bus fault protection branch according to an embodiment of this application.
FIG. 9 is a topological graph of a multi-port hybrid direct current circuit breaker provided with an auxiliary energy consumption branch and connected to a negative electrode of a direct current power grid system through a bus fault protection branch according to an embodiment of this application.
FIG. 10 is a topological graph of a multi-port hybrid direct current circuit breaker provided with an auxiliary energy consumption branch and connected to a positive electrode of a direct current power grid system through a bus fault protection branch according to an embodiment of this application.
FIG. 11 is a topological graph of a multi-port hybrid direct current circuit breaker provided with an auxiliary energy consumption branch and connected to a negative electrode of a direct current power grid system through a bus fault protection branch according to an embodiment of this application.
FIG. 12 is a schematic diagram of a breaking switch of a multi-port hybrid direct current circuit breaker according to an embodiment of this application.

### DETAILED DESCRIPTION

In the current Background Art, a multi-port direct current circuit breaker is used in the prior art, and the number of semiconductors arranged on a current flowing path of the multi-port direct current circuit breaker is often relatively large, resulting in high through-flow loss. In the aspect of a bus fault protection circuit, only direct current bus faults are considered, and faults of two common buses in the multi-port direct current circuit breaker are not considered. Based on current industry requirements and technical situations, it can be seen that there is an urgent need for a multi-port direct current circuit breaker that can solve the above technical problems.

The following clearly and completely describes the technical solutions in the embodiments of this application with reference to the accompanying drawings in the embodiments of this application. Apparently, the described embodiments are some of the embodiments of this application rather than all of the embodiments. Based on the embodiments in this application, all the other embodiments obtained by those skilled in the art without making any creative efforts fall within the scope of protection of this application.

It is to be understood that the terms "comprise" and "include" used in the description and claims of this application indicate the presence of the described characteristics, entity, steps, operations, elements and/or components, but do not exclude the presence or addition of one or more other characteristics, entity, steps, operations, elements, components and/or sets thereof.

In this application, the use of ordinal terms such as "first" and "second" to modify an element does not mean any priority, rank or order of one element relative to another, or the time order of performing actions in a method. Unless otherwise specified, such ordinal numbers are only used as a label to distinguish one element with a specific name from another element with the same name (except ordinal numbers in one embodiment). In all the accompanying drawings, unless otherwise defined in the context, it is to be noted that similar or same components with the same function are denoted by the same reference numerals, and different embodiments of similar or same components with the same function are distinguished by different letter suffixes of the same reference numerals.

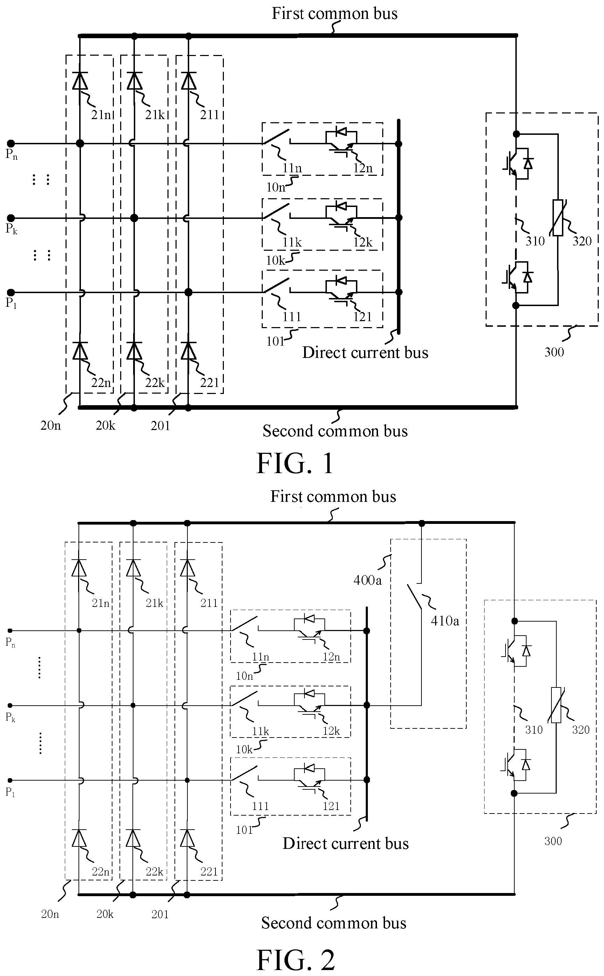

FIG. 1 is a topological graph of a multi-port hybrid direct current circuit breaker according to an embodiment of this application.

As shown in FIG. 1, a multi-port hybrid direct current circuit breaker includes n through-flow branches 101... 10k... 10n, n reversing branches 201...20k...20n, and 1 breaking branch 300; n is the total number of ports, k represents any k^{th} branch, k ranges from 1 to n, and n is a positive integer.

Each through-flow branch 10k includes a first fast mechanical switch 11k and a one-way commutation switch 12k which are connected in series. Each reversing branch 20k includes a diode upper bridge arm 21k and a diode lower bridge arm 22k which are connected in series in the same direction. The through-flow branches 10k correspond to the reversing branches 20k one to one. One ends of all the through-flow branches 101-10n are connected with each other to form a direct current bus, namely one ends of all the through-flow branches 101-10n are connected to the direct current bus. The other end of each through-flow branch 10k is connected to an intermediate point, between the diode upper bridge arm 21k and the diode lower bridge arm 22k, of the reversing branch 20k to form a port Pₖ, and the port is connected to a device or a line which needs to be protected. The breaking branch 300 includes a one-way breaking switch 310 and a nonlinear resistor 320 which are connected in parallel.

The breaking branch 300 and all the reversing branches 201-20n are connected in parallel to form a first common bus and a second common bus. The current breaking direction of the one-way breaking switch 310 of the breaking branch 300 is the direction that the first common bus points to the second common bus, namely the one-way breaking switch is configured to break current flowing from the first common bus to the second common bus. Cathodes of diode upper bridge arms 211-21n of the reversing branches 201-20n are connected to the first common bus, and anodes of diode lower bridge arms 221-22n of the reversing branches 201-20n are connected to the second common bus. The current breaking directions of the one-way commutation switches 121-12n of all the through-flow branches 101-10n are the same, namely all the one-way commutation switches point to the direct current bus or the ports.

According to the embodiment, the multi-port hybrid direct current circuit breaker can be applied to occasions without considering direct current bus faults.

According to the embodiment, the working modes of the multi-port hybrid direct current circuit breaker include a normal operation mode, an opening mode and a closing mode.

When the multi-port hybrid direct current circuit breaker is in the normal operation mode, first fast mechanical switches 111-11n and the one-way commutation switches 121-12n of the through-flow branches 101-10n are in an on state, and the one-way breaking switch 310 of the breaking branch 300 is in an off state.

When the multi-port hybrid direct current circuit breaker is in the opening mode, and the Pₖ^{th} port connected to the multi-port hybrid direct current circuit breaker needs to be cut off, the action process is as follows.

Step I: Control the one-way breaking switch 310 of the breaking branch 300 to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switch 11k of the through-flow branch 10k of the Pₖ^{th} port to be opened when the current of all the through-flow branches 101-10n is close to zero.

Step III: Control the one-way breaking switch 310 of the breaking branch 300 to be off, and control the one-way commutation switches 121-12n of all the through-flow branches to be on when the first fast mechanical switch 11k of the through-flow branch 10k of the Pₖ^{th} port is opened to an insulation voltage position, transfer the current of the Pₖ^{th} port to the nonlinear resistor 320 of the breaking branch 300 and gradually reduce the current to zero, recover the current of other ports which are not the Pₖ^{th} port to related through-flow branches, successfully open, and finish the opening operation.

When the multi-port hybrid direct current circuit breaker is in the closing mode and the Pₖ^{th} port connected to the multi-port hybrid direct current circuit breaker needs to be connected, the action process is as follows.

Step I: Control the one-way breaking switch 310 of the breaking branch 300 to be on.

Step II: Control the first fast mechanical switch 11k of the through-flow branch 10k of the Pₖ^{th} port to be on if the multi-port hybrid direct current circuit breaker is not closed due to a fault; and control the one-way breaking switch 310 of the breaking branch 300 to be off if the multi-port hybrid direct current circuit breaker is closed due to a fault, unsuccessfully close, and finish the closing operation.

Step III: Control the one-way breaking switch 310 of the breaking branch 300 to be off when the first fast mechanical switch 11k of the through-flow branch 10k of the Pₖ^{th} port is in a closing position, successfully close, and finish the closing operation.

The multi-port hybrid direct current circuit breaker is also provided with a bus fault protection branch, and the bus fault protection branch includes a second fast mechanical switch. One end of the second fast mechanical switch is connected to the direct current bus, and the other end of the second fast mechanical switch is connected to the first common bus or the second common bus.

When the multi-port hybrid direct current circuit breaker is in a bus fault protection mode, and the direct current bus or the first common bus or the second common bus has a grounding fault, the direct current circuit breaker cannot implement a bus isolation operation, and therefore the second fast mechanical switch of the bus fault protection branch is controlled to be on to start backup failure protection.

FIG. 2 is a second topological graph of a multi-port hybrid direct current circuit breaker connected to a positive electrode of a direct current power grid system according to an embodiment of this application; and compared with the multi-port hybrid direct current circuit breaker shown in FIG. 1, a bus fault protection branch 400a is added in the embodiment.

The bus fault protection branch 400a includes a second fast mechanical switch 410a; and one end of the second fast mechanical switch 410a is connected to the direct current bus, and the other end of the second fast mechanical switch is connected to the first common bus.

According to the embodiment, the working modes of the multi-port hybrid direct current circuit breaker include the normal operation mode, the opening mode, the closing mode and a bus fault protection mode.

It is to be understood that one end of the bus fault protection branch can be connected to the first common bus, and the other end of the bus fault protection branch can be connected to the direct current bus; or one end of the bus fault protection branch can be connected to the second common bus, and the other end of the bus fault protection branch is connected to the direct current bus; when the multi-port hybrid direct current circuit breaker is connected to the positive electrode of the direct current power grid system, one end of the bus fault protection branch is connected to the direct current bus, and the other end of the bus fault protection branch is connected to the first common bus; and when the multi-port hybrid direct current circuit breaker is connected to the negative electrode of the direct current power grid system, one end of the bus fault protection branch is connected to the direct current bus, and the other end of the bus fault protection branch is connected to the second common bus.

According to the embodiment, when the multi-port hybrid direct current circuit breaker is in the normal operation mode, the first fast mechanical switches 111-11n and the one-way commutation switches 121-12n of the through-flow branches 101-10n are in an on state, the one-way breaking switch 310 of the breaking branch 300 is in an off state, and the second fast mechanical switch 410a of the bus fault protection branch 400a is also in an off state.

When the multi-port hybrid direct current circuit breaker is in the opening mode, and the Pₖ^{th} port connected to the multi-port hybrid direct current circuit breaker needs to be cut off, the action process is as follows.

Step I: Control the one-way breaking switch 310 of the breaking branch 300 to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switch 11k of the through-flow branch 10k of the Pₖ^{th} port to be opened when the current of all the through-flow branches 101-10n is close to zero.

Step III: Control the one-way breaking switch 310 of the breaking branch 300 to be off, and control the one-way commutation switches 121-12n of all the through-flow branches to be on when the first fast mechanical switch 11k of the through-flow branch 10k of the Pₖ^{th} port is opened to an insulation voltage position, transfer the current of the Pₖ^{th} port to the nonlinear resistor 320 of the breaking branch 300 and gradually reduce the current to zero, recover the current of other ports which are not the Pₖ^{th} port to related through-flow branches, successfully open, and finish the opening operation.

When the multi-port hybrid direct current circuit breaker is in the closing mode and the Pₖ^{th} port connected to the multi-port hybrid direct current circuit breaker needs to be connected, the action process is as follows.

Step I: Control the one-way breaking switch 310 of the breaking branch 300 to be on.

Step II: Control the first fast mechanical switch 11k of the through-flow branch 10k of the Pₖ^{th} port to be on if the multi-port hybrid direct current circuit breaker is not closed due to a fault; and control the one-way breaking switch 310 of the breaking branch 300 to be off if the multi-port hybrid direct current circuit breaker is closed due to a fault, unsuccessfully close, and finish the closing operation.

Step III: Control the one-way breaking switch 310 of the breaking branch 300 to be off when the first fast mechanical switch 11k of the through-flow branch 10k of the Pₖ^{th} port is in a closing position, successfully close, and finish the closing operation.

When the multi-port hybrid direct current circuit breaker is in the bus fault protection mode, and the direct current bus or the first common bus or the second common bus has a grounding fault, the direct current circuit breaker cannot implement a bus isolation operation, and therefore the second fast mechanical switch 410a of the bus fault protection branch 400a is controlled to be on to start backup failure protection.

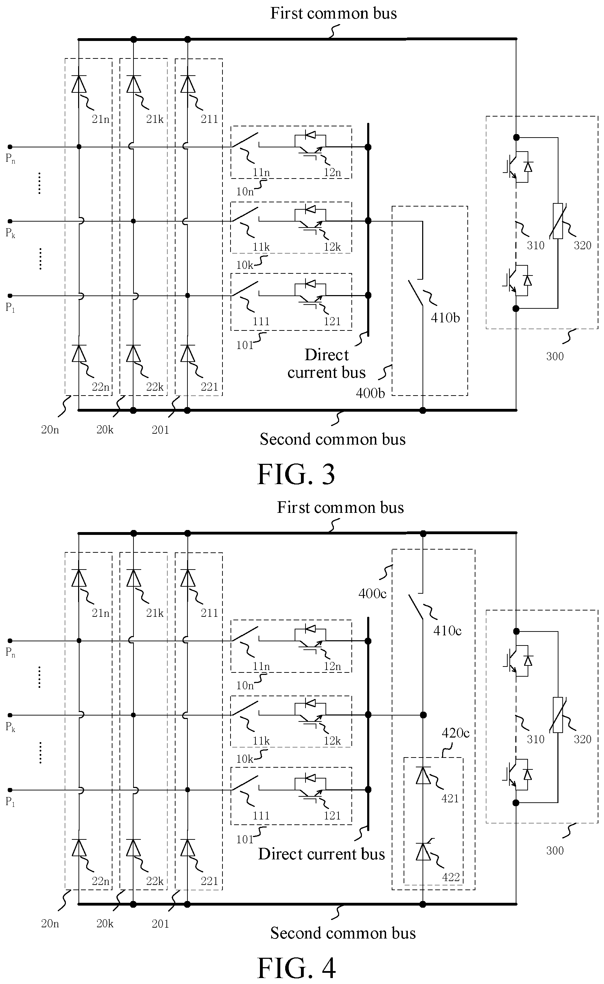

FIG. 3 is a second topological graph of a multi-port hybrid direct current circuit breaker connected to a negative electrode of a direct current power grid system according to an embodiment of this application; and compared with the embodiment shown in FIG. 1, a bus fault protection branch 400b is added in the embodiment.

The bus fault protection branch 400b includes a second fast mechanical switch 410b; and one end of the second fast mechanical switch 410b is connected to the direct current bus, and the other end of the second fast mechanical switch is connected to the second common bus.

According to the embodiment, the working modes of the multi-port hybrid direct current circuit breaker include the normal operation mode, the opening mode, the closing mode and a bus fault protection mode.

When the multi-port hybrid direct current circuit breaker is in the normal operation mode, the first fast mechanical switches 111-11n and the one-way commutation switches 121-12n of the through-flow branches 101-10n are in an on state, the one-way breaking switch 310 of the breaking branch 300 is in an off state, and the second fast mechanical switch 410 of the bus fault protection branch 400 is in an off state.

When the multi-port hybrid direct current circuit breaker is in the opening mode, and the Pₖ^{th} port connected to the multi-port hybrid direct current circuit breaker needs to be cut off, the action process is as follows.

Step I: Control the one-way breaking switch 310 of the breaking branch 300 to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switch 11k of the through-flow branch 10k of the Pₖ^{th} port to be opened when the current of all the through-flow branches 101-10n is close to zero.

Step III: Control the one-way breaking switch 310 of the breaking branch 300 to be off, and control the one-way commutation switches 121-12n of all the through-flow branches to be on when the first fast mechanical switch 11k of the through-flow branch 10k of the Pₖ^{th} port is opened to the insulation voltage position, transfer the current of the Pₖ^{th} port to the nonlinear resistor 320 of the breaking branch 300 and gradually reduce the current to zero, recover the current of other ports which are not the Pₖ^{th} port to related through-flow branches, successfully open, and finish the opening operation.

When the multi-port hybrid direct current circuit breaker is in the closing mode and the Pₖ^{th} port connected to the multi-port hybrid direct current circuit breaker needs to be connected, the action process is as follows.

Step I: Control the one-way breaking switch 310 of the breaking branch 300 to be on.

Step II: Control the first fast mechanical switch 11k of the through-flow branch 10k of the Pₖ^{th} port to be on if the multi-port hybrid direct current circuit breaker is not closed due to a fault; and control the one-way breaking switch 310 of the breaking branch 300 to be off if the multi-port hybrid direct current circuit breaker is closed due to a fault, unsuccessfully close, and finish the closing operation.

Step III: Control the one-way breaking switch 310 of the breaking branch 300 to be off when the first fast mechanical switch 11k of the through-flow branch 10k of the Pₖ^{th} port is in a closing position, successfully close, and finish the closing operation.

When the multi-port hybrid direct current circuit breaker is in the bus fault protection mode, and the direct current bus or the first common bus or the second common bus has a grounding fault, the direct current circuit breaker cannot implement the bus isolation operation, and therefore the second fast mechanical switch 410b of the bus fault protection branch 400b is controlled to be on to start backup failure protection.

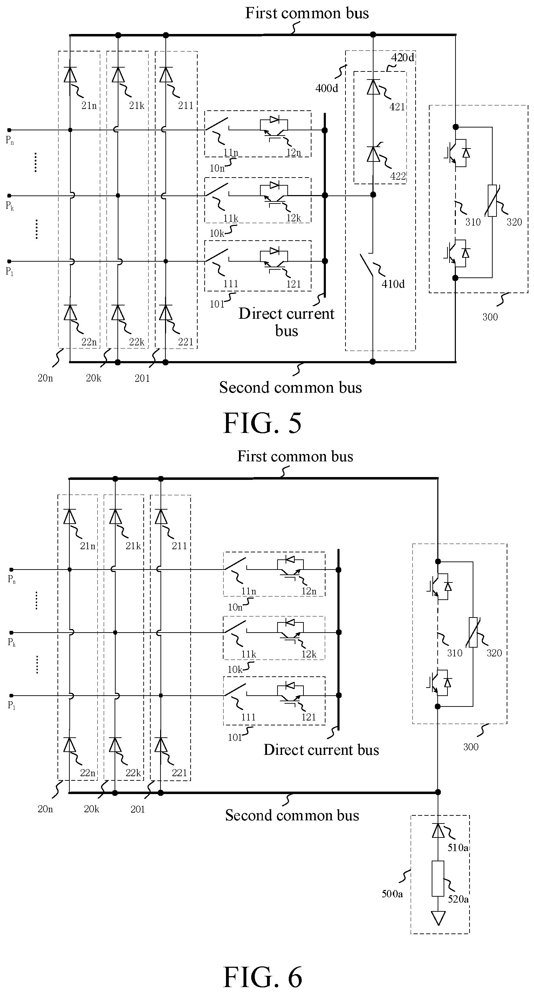

The difference between the embodiments shown in FIG. 4 and FIG. 5 and the embodiments shown in FIG. 2 and FIG. 3 is that the bus fault protection branch of the multi-port hybrid direct current circuit breaker further includes a one-way conduction switch; and one end of the one-way conduction switch is connected to the direct current bus, and the other end of the one-way conduction switch is connected to a common bus which is not connected with the second fast mechanical switch, that is, when one end of the second fast mechanical switch is connected to the first common bus, the other end of the one-way conduction switch is connected to the second common bus, and vice versa.

FIG. 4 is a third topological graph of a multi-port hybrid direct current circuit breaker connected to a positive electrode of a direct current power grid system according to an embodiment of this application; and compared with the embodiment shown in FIG. 1, a bus fault protection branch 400c is added in the embodiment.

The bus fault protection branch 400c includes a second fast mechanical switch 410c and a one-way conduction switch 420c which are connected in series; one end of the second fast mechanical switch 410c is connected to the direct current bus, and the other end of the second fast mechanical switch is connected to the first common bus; and one end of the one-way conduction switch 420c is connected to the direct current bus, and the other end of the one-way conduction switch is connected to the second common bus. An intermediate point between the second fast mechanical switch 410c and the one-way conduction switch 420c of the bus fault protection branch 400c is connected to the direct current bus. The conduction direction of the one-way conduction switch 420c is the direction that the second common bus points to the direct current bus. In addition, the current breaking directions of the one-way commutation switches 121-12n of the through-flow branches 101-10n point to the direction of the direct current bus.

According to the embodiment, the working modes of the multi-port hybrid direct current circuit breaker include the normal operation mode, the opening mode, the closing mode and a bus fault protection mode.

When the multi-port hybrid direct current circuit breaker is in the normal operation mode, the first fast mechanical switches 111-11n and the one-way commutation switches 121-12n of the through-flow branches 101-10n are in an on state, the one-way breaking switch 310 of the breaking branch 300 is in an off state, and the second fast mechanical switch 410 and the one-way conduction switch 420 of the bus fault protection branch 400 are in an off state.

When the multi-port hybrid direct current circuit breaker is in the opening mode, and the Pₖ^{th} port connected to the multi-port hybrid direct current circuit breaker needs to be cut off, the action process is as follows.

Step I: Control the one-way breaking switch 310 of the breaking branch 300 to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switch 11k of the through-flow branch 10k of the Pₖ^{th} port to be opened when the current of all the through-flow branches 101-10n is close to zero.

Step III: Control the one-way breaking switch 310 of the breaking branch 300 to be off, and control the one-way commutation switches 121-12n of all the through-flow branches to be on when the first fast mechanical switch 11k of the through-flow branch 10k of the Pₖ^{th} port is opened to the insulation voltage position, transfer the current of the Pₖ^{th} port to the nonlinear resistor 320 of the breaking branch 300 and gradually reduce the current to zero, recover the current of other ports which are not the Pₖ^{th} port to related through-flow branches, successfully open, and finish the opening operation.

When the multi-port hybrid direct current circuit breaker is in the closing mode and the Pₖ^{th} port connected to the multi-port hybrid direct current circuit breaker needs to be connected, the action process is as follows.

Step I: Control the one-way breaking switch 310 of the breaking branch 300 to be on.

Step II: Control the first fast mechanical switch 11k of the through-flow branch 10k of the Pₖ^{th} port to be on if the multi-port hybrid direct current circuit breaker is not closed due to a fault; and control the one-way breaking switch 310 of the breaking branch 300 to be off if the multi-port hybrid direct current circuit breaker is closed due to a fault, unsuccessfully close, and finish the closing operation.

Step III: Control the one-way breaking switch 310 of the breaking branch 300 to be off when the first fast mechanical switch 11k of the through-flow branch 10k of the Pₖ^{th} port is in a closing position, successfully close, and finish the closing operation.

When the multi-port hybrid direct current circuit breaker is in the bus fault protection mode and the direct current bus has a grounding fault, the action process is as follows.

Step I: Control the one-way breaking switch 310 of the breaking branch 300 to be on, control the one-way conduction switch 420c of the bus fault protection branch 400c to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switches 111-11n of all the through-flow branches 101-10n to be opened when the current of all the through-flow branches 101-10n is close to zero.

Step III: Control the one-way breaking switch 310 of the breaking branch 300 to be off, and control the one-way commutation switches 121-12n of all the through-flow branches 101-10n to be on when the first fast mechanical switches 111-11n of all the through-flow branches 101-10n are opened to the insulation voltage position, transfer the current to the nonlinear resistor 320 of the breaking branch 300 and reduce the current to zero, successfully open, and finish the opening operation.

When the multi-port hybrid direct current circuit breaker is in the bus fault protection mode, and the first common bus has a grounding fault, the multi-port hybrid direct current circuit breaker cannot implement the bus isolation operation, and therefore the second fast mechanical switch 410c of the bus fault protection branch 400c is controlled to be on to start backup failure protection.

When the multi-port hybrid direct current circuit breaker is in the bus fault protection mode and the second common bus has a grounding fault, the bus differential protection of the multi-port hybrid direct current circuit breaker in the normal operation mode cannot act. If the opening operation is carried out at the moment, the bus differential protection will act, and the direct current circuit breaker can stop the opening operation and start backup failure protection.

FIG. 5 is a third topological graph of a multi-port hybrid direct current circuit breaker connected to a negative electrode of a direct current power grid system according to an embodiment of this application; and compared with the multi-port hybrid direct current circuit breaker according to this application shown in FIG. 1, a bus fault protection branch 400d is added in the embodiment.

The bus fault protection branch 400d includes a second fast mechanical switch 410d and a one-way conduction switch 420d which are connected in series. The second fast mechanical switch 410d is connected to the second common bus. The one-way conduction switch 420d is connected to the first common bus; an intermediate point of the bus fault protection branch 400d is connected to the direct current bus; and the conduction direction of the one-way conduction switch 420d is the direction that the direct current bus points to the first common bus. In addition, the current breaking directions of the one-way commutation switches 121-12n of the through-flow branches 101-10n point to the ports.

According to the embodiment, the working modes of the multi-port hybrid direct current circuit breaker include the normal operation mode, the opening mode, the closing mode and a bus fault protection mode.

When the multi-port hybrid direct current circuit breaker is in the normal operation mode, the first fast mechanical switches 111-11n and the one-way commutation switches 121-12n of the through-flow branches 101-10n are in an on state, the one-way breaking switch 310 of the breaking branch 300 is in an off state, and the second fast mechanical switch 410 and the one-way conduction switch 420 of the bus fault protection branch 400 are in an off state.

When the multi-port hybrid direct current circuit breaker is in the opening mode, and the Pₖ^{th} port connected to the multi-port hybrid direct current circuit breaker needs to be cut off, the action process is as follows.

Step I: Control the one-way breaking switch 310 of the breaking branch 300 to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switch 11k of the through-flow branch 10k of the Pₖ^{th} port to be opened when the current of all the through-flow branches 101-10n is close to zero.

Step III: Control the one-way breaking switch 310 of the breaking branch 300 to be off, and control the one-way commutation switches 121-12n of all the through-flow branches to be on when the first fast mechanical switch 11k of the through-flow branch 10k of the Pₖ^{th} port is opened to the insulation voltage position, transfer the current of the Pₖ^{th} port to the nonlinear resistor 320 of the breaking branch 300 and gradually reduce the current to zero, recover the current of other ports which are not the Pₖ^{th} port to related through-flow branches, successfully open, and finish the opening operation.

When the multi-port hybrid direct current circuit breaker is in the closing mode and the Pₖ^{th} port connected to the multi-port hybrid direct current circuit breaker needs to be connected, the action process is as follows.

Step I: Control the one-way breaking switch 310 of the breaking branch 300 to be on.

Step II: Control the first fast mechanical switch 11k of the through-flow branch 10k of the Pₖ^{th} port to be on if the multi-port hybrid direct current circuit breaker is not closed due to a fault; and control the one-way breaking switch 310 of the breaking branch 300 to be off if the multi-port hybrid direct current circuit breaker is closed due to a fault, unsuccessfully close, and finish the closing operation.

Step III: Control the one-way breaking switch 310 of the breaking branch 300 to be off when the first fast mechanical switch 11k of the through-flow branch 10k of the Pₖ^{th} port is in a closing position, successfully close, and finish the closing operation.

When the multi-port hybrid direct current circuit breaker is in the bus fault protection mode and the direct current bus has a grounding fault, the action process is as follows.

Step I: Control the one-way breaking switch 310 of the breaking branch 300 to be on, control the one-way conduction switch 420 of the bus fault protection branch 400 to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switches 111-11n of all the through-flow branches 101-10n to be opened when the current of all the through-flow branches 101-10n is close to zero.

Step III: Control the one-way breaking switch 310 of the breaking branch 300 to be off, and control the one-way commutation switches 121-12n of all the through-flow branches 101-10n to be on when the first fast mechanical switches 111-11n of all the through-flow branches 101-10n are opened to the insulation voltage position, transfer the current to the nonlinear resistor 320 of the breaking branch 300 and reduce the current to zero, successfully open, and finish the opening operation.

The multi-port hybrid direct current circuit breaker is in the bus fault protection mode, and when the first common bus has a grounding fault, bus differential protection of the multi-port hybrid direct current circuit breaker in the normal operation mode cannot act; and if the opening operation is carried out at the moment, the bus differential protection will act, and the direct current circuit breaker can stop the opening operation and start backup failure protection.

The multi-port hybrid direct current circuit breaker is in the bus fault protection mode, and when the second common bus has a grounding fault, the multi-port hybrid direct current circuit breaker cannot implement the bus isolation operation, so the second fast mechanical switch 410d of the bus fault protection branch 400d is controlled to be on to start the backup failure protection.

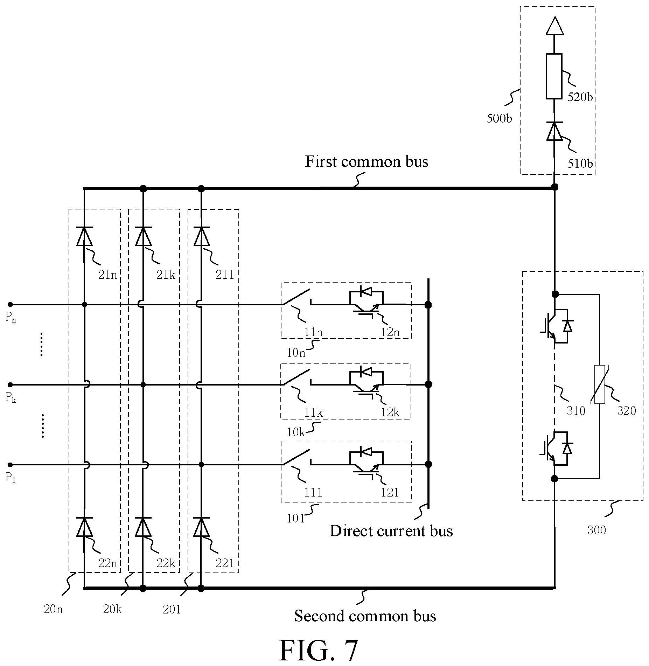

The difference between the embodiments shown in FIG. 6 and FIG. 7 and the embodiments shown in FIG. 4 and FIG. 5 is that the multi-port hybrid direct current circuit breaker may be not provided with the bus fault protection branch; an auxiliary energy consumption circuit can be additionally arranged in a case that the bus fault protection circuit is not arranged; and one end of the auxiliary energy consumption circuit can be connected to the first common bus or the second common bus.

FIG. 6 is a fourth topological graph of a multi-port hybrid direct current circuit breaker connected to a positive electrode of a direct current power grid system according to an embodiment of this application; and compared with the embodiment shown in FIG. 1, an auxiliary energy consumption branch 500a is added in the embodiment.

The auxiliary energy consumption branch 500a includes a diode 510a and a linear resistor 520a which are connected in series. One end of the auxiliary energy consumption branch 500a is connected to the second common bus, and the other end of the auxiliary energy consumption branch is connected to the ground or a metal loop. A cathode of the diode 510a points to the second common bus. The topological solution can be applied to occasions without considering direct current bus faults. According to the embodiment, the working modes of the multi-port hybrid direct current circuit breaker include the normal operation mode, the opening mode and the closing mode.

When the multi-port hybrid direct current circuit breaker is in the normal operation mode, the first fast mechanical switches 111-11n and the one-way commutation switches 121-12n of the through-flow branches 101-10n are in an on state, and the one-way breaking switch 310 of the breaking branch 300 is in an off state.

When the multi-port hybrid direct current circuit breaker is in the opening mode, and the Pₖ^{th} port connected to the multi-port hybrid direct current circuit breaker needs to be cut off, the action process is as follows.

Step I: Control the one-way breaking switch 310 of the breaking branch 300 to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switch 11k of the through-flow branch 10k of the Pₖ^{th} port to be opened when the current of all the through-flow branches 101-10n is close to zero.

Step III: Control the one-way breaking switch 310 of the breaking branch 300 to be off, and control the one-way commutation switches 121-12n of all the through-flow branches to be on when the first fast mechanical switch 11k of the through-flow branch 10k of the Pₖ^{th} port is opened to the insulation voltage position, transfer the current of the Pₖ^{th} port to the nonlinear resistor 320 of the breaking branch 300 and the linear resistor 520a of the auxiliary energy consumption branch 500a and gradually reduce the current to zero, recover the current of other ports which are not the Pₖ^{th} port to related through-flow branches, successfully open, and finish the opening operation.

When the multi-port hybrid direct current circuit breaker is in the closing mode and the Pₖ^{th} port connected to the multi-port hybrid direct current circuit breaker needs to be connected, the action process is as follows.

Step I: Control the one-way breaking switch 310 of the breaking branch 300 to be on.

Step II: Control the first fast mechanical switch 11k of the through-flow branch 10k of the Pₖ^{th} port to be on if the multi-port hybrid direct current circuit breaker is not closed due to a fault; and control the one-way breaking switch 310 of the breaking branch 300 to be off if the multi-port hybrid direct current circuit breaker is closed due to a fault, unsuccessfully close, and finish the closing operation.

Step III: Control the one-way breaking switch 310 of the breaking branch 300 to be off when the first fast mechanical switch 11k of the through-flow branch 10k of the Pₖ^{th} port is in a closing position, successfully close, and finish the closing operation.

FIG. 7 is a fourth topological graph of a multi-port hybrid direct current circuit breaker connected to a negative electrode of a direct current power grid system according to an embodiment of this application; compared with the embodiment shown in FIG. 1, an auxiliary energy consumption branch 500b is added in the embodiment; and the auxiliary energy consumption branch 500b includes a diode 510b and a linear resistor 520b which are connected in series.

One end of the auxiliary energy consumption branch 500b is connected to the first common bus, and the other end of the auxiliary energy consumption branch is connected to the ground or the metal loop; and an anode of the diode 510b points to the first common bus. According to the embodiment, the multi-port hybrid direct current circuit breaker can be applied to occasions without considering direct current bus faults; and the working modes of the multi-port hybrid direct current circuit breaker include the normal operation mode, the opening mode and the closing mode.

When the multi-port hybrid direct current circuit breaker is in the normal operation mode, the first fast mechanical switches 111-11n and the one-way commutation switches 121-12n of the through-flow branches 101-10n are in an on state, and the one-way breaking switch 310 of the breaking branch 300 is in an off state.

When the multi-port hybrid direct current circuit breaker is in the opening mode, and the Pₖ^{th} port connected to the multi-port hybrid direct current circuit breaker needs to be cut off, the action process is as follows.

Step I: Control the one-way breaking switch 310 of the breaking branch 300 to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switch 11k of the through-flow branch 10k of the Pₖ^{th} port to be opened when the current of all the through-flow branches 101-10n is close to zero.

Step III: Control the one-way breaking switch 310 of the breaking branch 300 to be off, and control the one-way commutation switches 121-12n of all the through-flow branches to be on when the first fast mechanical switch 11k of the through-flow branch 10k of the Pₖ^{th} port is opened to the insulation voltage position, transfer the current of the Pₖ^{th} port to the nonlinear resistor 320 of the breaking branch 300 and the linear resistor 520 of the auxiliary energy consumption branch 500 and gradually reduce the current to zero, recover the current of other ports which are not the Pₖ^{th} port to related through-flow branches, successfully open, and finish the opening operation.

When the multi-port hybrid direct current circuit breaker is in the closing mode and the Pₖ^{th} port connected to the multi-port hybrid direct current circuit breaker needs to be connected, the action process is as follows.

Step I: Control the one-way breaking switch 310 of the breaking branch 300 to be on.

Step II: Control the first fast mechanical switch 11k of the through-flow branch 10k of the Pₖ^{th} port to be on if the multi-port hybrid direct current circuit breaker is not closed due to a fault; and control the one-way breaking switch 310 of the breaking branch 300 to be off if the multi-port hybrid direct current circuit breaker is closed due to a fault, unsuccessfully close, and finish the closing operation.

Step III: Control the one-way breaking switch 310 of the breaking branch 300 to be off when the first fast mechanical switch 11k of the through-flow branch 10k of the Pₖ^{th} port is in a closing position, successfully close, and finish the closing operation.

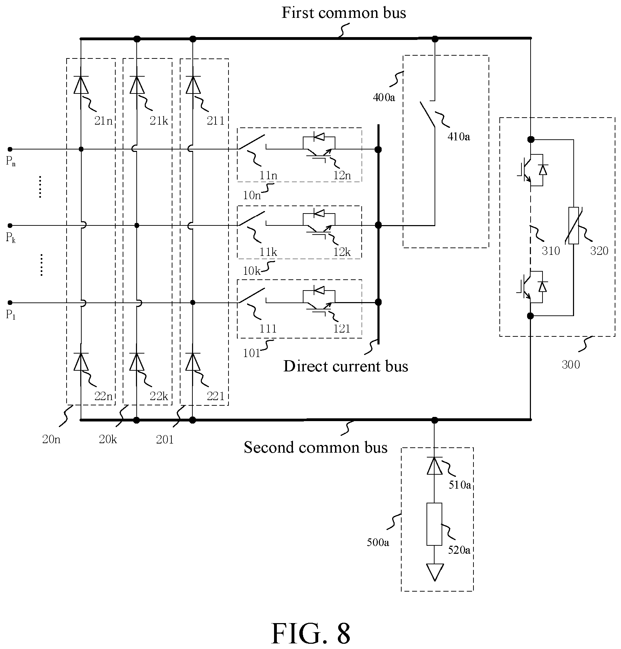

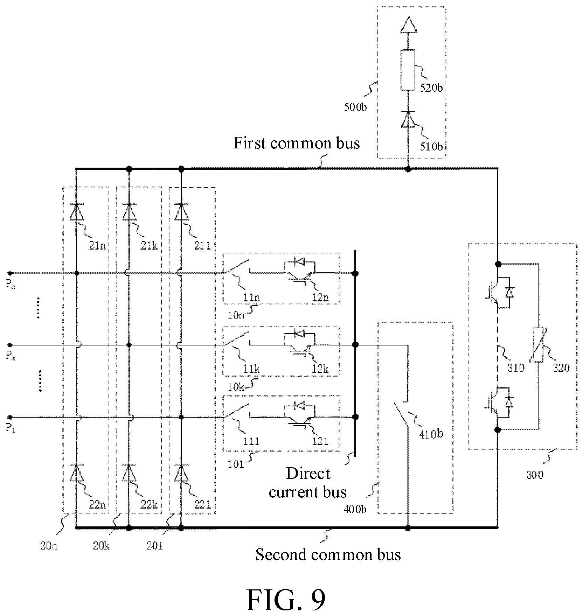

The difference between the embodiments shown in FIG. 8 and FIG. 9 and the embodiments shown in FIG. 7 and FIG. 8 is that the multi-port hybrid direct current circuit breaker can be additionally provided with the bus fault protection circuit under a condition that the auxiliary energy consumption circuit is arranged; one end of the auxiliary energy consumption circuit can be connected to the first common bus or the second common bus; when one end of the auxiliary energy consumption circuit is connected to the second common bus, the bus fault protection circuit is connected between the first common bus and the direct current bus; and when one end of the auxiliary energy consumption circuit is connected to the first common bus, the bus fault protection circuit is connected between the second common bus and the direct current bus.

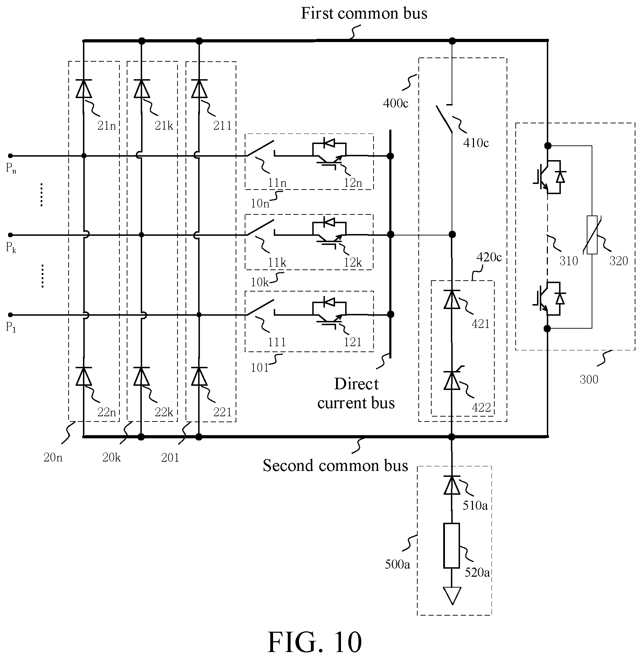

The difference between the embodiment shown in FIG. 10 and the embodiments shown in FIG. 8 and FIG. 9 is that the bus fault protection branch also includes a one-way conduction switch; and one end of the one-way conduction switch is connected to the direct current bus, and the other end of the one-way conduction switch is connected to the common bus which is not connected with the second fast mechanical switch.

FIG. 8 is a fifth topological graph of a multi-port hybrid direct current circuit breaker connected to a positive electrode of a direct current power grid system according to an embodiment of this application; and compared with the embodiment shown in FIG. 1, the bus fault protection branch 400a and the auxiliary energy consumption branch 500a are added in the embodiment.

The bus fault protection branch 400a includes a second fast mechanical switch 410a; and one end of the second fast mechanical switch 410a is connected to the direct current bus, and the other end of the second fast mechanical switch is connected to the first common bus. The auxiliary energy consumption branch 500a includes a diode 510a and a linear resistor 520a which are connected in series; one end of the auxiliary energy consumption branch 500a is connected to the second common bus, and the other end of the auxiliary energy consumption branch is connected to the ground or the metal loop; and the cathode of the diode 510a points to the second common bus. According to the embodiment, the working modes of the multi-port hybrid direct current circuit breaker include the normal operation mode, the opening mode, the closing mode and a bus fault protection mode.

When the multi-port hybrid direct current circuit breaker is in the normal operation mode, the first fast mechanical switches 111-11n and the one-way commutation switches 121-12n of the through-flow branches 101-10n are in an on state, the one-way breaking switch 310 of the breaking branch 300 is in an off state, and the second fast mechanical switch 410a of the bus fault protection branch 400a is in an off state.

When the multi-port hybrid direct current circuit breaker is in the opening mode, and the Pₖ^{th} port connected to the multi-port hybrid direct current circuit breaker needs to be cut off, the action process is as follows.

Step I: Control the one-way breaking switch 310 of the breaking branch 300 to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switch 11k of the through-flow branch 10k of the Pₖ^{th} port to be opened when the current of all the through-flow branches 101-10n is close to zero.

Step III: Control the one-way breaking switch 310 of the breaking branch 300 to be off, and control the one-way commutation switches 121-12n of all the through-flow branches to be on when the first fast mechanical switch 11k of the through-flow branch 10k of the Pₖ^{th} port is opened to the insulation voltage position, transfer the current of the Pₖ^{th} port to the nonlinear resistor 320 of the breaking branch 300 and the linear resistor 520a of the auxiliary energy consumption branch 500a and gradually reduce the current to zero, recover the current of other ports which are not the Pₖ^{th} port to related through-flow branches, successfully open, and finish the opening operation.

When the multi-port hybrid direct current circuit breaker is in the closing mode and the Pₖ^{th} port connected to the multi-port hybrid direct current circuit breaker needs to be connected, the action process is as follows.

Step I: Control the one-way breaking switch 310 of the breaking branch 300 to be on.

Step II: Control the first fast mechanical switch 11k of the through-flow branch 10k of the Pₖ^{th} port to be on if the multi-port hybrid direct current circuit breaker is not closed due to a fault; and control the one-way breaking switch 310 of the breaking branch 300 to be off if the multi-port hybrid direct current circuit breaker is closed due to a fault, unsuccessfully close, and finish the closing operation.

Step III: Control the one-way breaking switch 310 of the breaking branch 300 to be off when the first fast mechanical switch 11k of the through-flow branch 10k of the Pₖ^{th} port is in a closing position, successfully close, and finish the closing operation.

When the multi-port hybrid direct current circuit breaker is in the bus fault protection mode, and the direct current bus or the first common bus or the second common bus has a grounding fault, the direct current circuit breaker cannot implement the bus isolation operation, and therefore the second fast mechanical switch 410a of the bus fault protection branch 400a is controlled to be on to start backup failure protection.

FIG. 9 is a fifth topological graph of a multi-port hybrid direct current circuit breaker connected to a negative electrode of a direct current power grid system according to an embodiment of this application; and compared with the embodiment shown in FIG. 1, the bus fault protection branch 400b and the auxiliary energy consumption branch 500b are added in the embodiment.

The bus fault protection branch 400b includes the second fast mechanical switch 410b; and one end of the second fast mechanical switch 410b is connected to the direct current bus, and the other end of the second fast mechanical switch is connected to the second common bus. The auxiliary energy consumption branch 500b includes the diode 510b and the linear resistor 520b which are connected in series. One end of the auxiliary energy consumption branch 500b is connected to the first common bus, and the other end of the auxiliary energy consumption branch is connected to the ground or the metal loop; and the anode of the diode 510b points to the first common bus.

According to the embodiment, the working modes of the multi-port hybrid direct current circuit breaker include the normal operation mode, the opening mode, the closing mode and a bus fault protection mode.

When the multi-port hybrid direct current circuit breaker is in the normal operation mode, the first fast mechanical switches 111-11n and the one-way commutation switches 121-12n of the through-flow branches 101-10n are in an on state, the one-way breaking switch 310 of the breaking branch 300 is in an off state, and the second fast mechanical switch 410b of the bus fault protection branch 400b is in an off state.

When the multi-port hybrid direct current circuit breaker is in the opening mode, and the Pₖ^{th} port connected to the multi-port hybrid direct current circuit breaker needs to be cut off, the action process is as follows.

Step I: Control the one-way breaking switch 310 of the breaking branch 300 to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switch 11k of the through-flow branch 10k of the Pₖ^{th} port to be opened when the current of all the through-flow branches 101-10n is close to zero.

Step III: Control the one-way breaking switch 310 of the breaking branch 300 to be off, and control the one-way commutation switches 121-12n of all the through-flow branches to be on when the first fast mechanical switch 11k of the through-flow branch 10k of the Pₖ^{th} port is opened to the insulation voltage position, transfer the current of the Pₖ^{th} port to the nonlinear resistor 320 of the breaking branch 300 and the linear resistor 520b of the auxiliary energy consumption branch 500b and gradually reduce the current to zero, recover the current of other ports which are not the Pₖ^{th} port to related through-flow branches, successfully open, and finish the opening operation.

When the multi-port hybrid direct current circuit breaker is in the closing mode and the Pₖ^{th} port connected to the multi-port hybrid direct current circuit breaker needs to be connected, the action process is as follows.

Step I: Control the one-way breaking switch 310 of the breaking branch 300 to be on.

Step II: Control the first fast mechanical switch 11k of the through-flow branch 10k of the Pₖ^{th} port to be on if the multi-port hybrid direct current circuit breaker is not closed due to a fault; and control the one-way breaking switch 310 of the breaking branch 300 to be off if the multi-port hybrid direct current circuit breaker is closed due to a fault, unsuccessfully close, and finish the closing operation.

Step III: Control the one-way breaking switch 310 of the breaking branch 300 to be off when the first fast mechanical switch 11k of the through-flow branch 10k of the Pₖ^{th} port is in a closing position, successfully close, and finish the closing operation.

When the multi-port hybrid direct current circuit breaker is in the bus fault protection mode, and the direct current bus or the first common bus or the second common bus has a grounding fault, the direct current circuit breaker cannot implement the bus isolation operation, and therefore the second fast mechanical switch 410b of the bus fault protection branch 400b is controlled to be on to start backup failure protection.

FIG. 10 is a sixth topological graph of a multi-port hybrid direct current circuit breaker connected to a positive electrode of a direct current power grid system according to an embodiment of this application; and compared with the embodiment shown in FIG. 1, the bus fault protection branch 400c and the auxiliary energy consumption branch 500a are added.

The bus fault protection branch 400c includes the second fast mechanical switch 410c and the one-way conduction switch 420c which are connected in series; the second fast mechanical switch 410c is connected to the first common bus; the one-way conduction switch 420c is connected to the second common bus; the intermediate point of the bus fault protection branch 400c is connected to the direct current bus; and the conduction direction of the one-way conduction switch 420c is the direction that the second common bus points to the direct current bus.

The auxiliary energy consumption branch 500a includes the diode 510a and the linear resistor 520a which are connected in series; one end of the auxiliary energy consumption branch 500a is connected to the second common bus, and the other end of the auxiliary energy consumption branch is connected to the ground or the metal loop; and the cathode of the diode 510a points to the second common bus. In addition, the current breaking directions of the one-way commutation switches 121-12n of the through-flow branches 101-10n point to the direct current bus. According to the embodiment, the working modes of the multi-port hybrid direct current circuit breaker include the normal operation mode, the opening mode, the closing mode and a bus fault protection mode.

When the multi-port hybrid direct current circuit breaker is in the normal operation mode, the first fast mechanical switches 111-11n and the one-way commutation switches 121-12n of the through-flow branches 101-10n are in an on state, the one-way breaking switch 310 of the breaking branch 300 is in an off state, and the second fast mechanical switch 410b and the one-way conduction switch 420b of the bus fault protection branch 400b are in an off state.

When the multi-port hybrid direct current circuit breaker is in the opening mode, and the Pₖ^{th} port connected to the multi-port hybrid direct current circuit breaker needs to be cut off, the action process is as follows.

Step I: Control the one-way breaking switch 310 of the breaking branch 300 to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switch 11k of the through-flow branch 10k of the Pₖ^{th} port to be opened when the current of all the through-flow branches 101-10n is close to zero.

Step III: Control the one-way breaking switch 310 of the breaking branch 300 to be off, and control the one-way commutation switches 121-12n of all the through-flow branches to be on when the first fast mechanical switch 11k of the through-flow branch 10k of the Pₖ^{th} port is opened to the insulation voltage position, transfer the current of the Pₖ^{th} port to the nonlinear resistor 320 of the breaking branch 300 and the linear resistor 520a of the auxiliary energy consumption branch 500a and gradually reduce the current to zero, recover the current of other ports which are not the Pₖ^{th} port to related through-flow branches, successfully open, and finish the opening operation.

When the multi-port hybrid direct current circuit breaker is in the closing mode and the Pₖ^{th} port connected to the multi-port hybrid direct current circuit breaker needs to be connected, the action process is as follows.

Step I: Control the one-way breaking switch 310 of the breaking branch 300 to be on.

Step II: Control the first fast mechanical switch 11k of the through-flow branch 10k of the Pₖ^{th} port to be on if the multi-port hybrid direct current circuit breaker is not closed due to a fault; and control the one-way breaking switch 310 of the breaking branch 300 to be off if the multi-port hybrid direct current circuit breaker is closed due to a fault, unsuccessfully close, and finish the closing operation.

Step III: Control the one-way breaking switch 310 of the breaking branch 300 to be off when the first fast mechanical switch 11k of the through-flow branch 10k of the Pₖ^{th} port is in a closing position, successfully close, and finish the closing operation.

When the multi-port hybrid direct current circuit breaker is in the bus fault protection mode and the direct current bus has a grounding fault, the action process is as follows.

Step I: Control the one-way breaking switch 310 of the breaking branch 300 to be on, control the one-way conduction switch 420c of the bus fault protection branch 400c to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switches 111-11n of all the through-flow branches 101-10n to be opened when the current of all the through-flow branches 101-10n is close to zero.

Step III: Control the one-way breaking switch 310 of the breaking branch 300 to be off, and control the one-way commutation switches 121-12n of all the through-flow branches 101-10n to be on when the first fast mechanical switches 111-11n of all the through-flow branches 101-10n are opened to the insulation voltage position, transfer the current to the nonlinear resistor 320 of the breaking branch 300 and reduce the current to zero, successfully open, and finish the opening operation.

When the multi-port hybrid direct current circuit breaker is in the bus fault protection mode, and the first common bus has a grounding fault, the multi-port hybrid direct current circuit breaker cannot implement the bus isolation operation, backup failure protection can be started, and the second fast mechanical switch 410c of the bus fault protection branch 400c is controlled to be on.

The multi-port hybrid direct current circuit breaker is in the bus fault protection mode, the bus differential protection of the multi-port hybrid direct current circuit breaker in the normal operation mode cannot act, so if the opening operation is carried out at the moment, the bus differential protection will act, and the direct current circuit breaker can stop the opening operation to start backup failure protection.

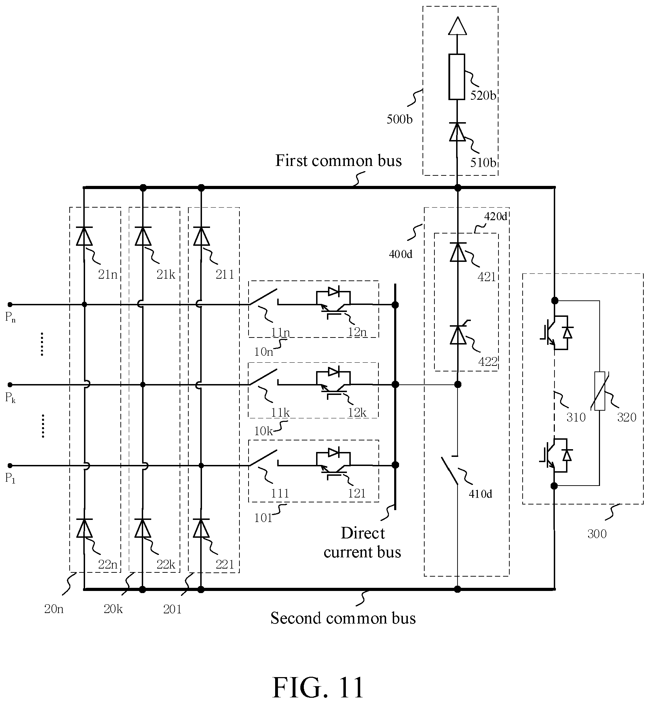

FIG. 11 is a sixth topological graph of a multi-port hybrid direct current circuit breaker connected to a negative electrode of a direct current power grid system according to an embodiment of this application.

Compared with the embodiment shown in FIG. 1, the bus fault protection branch 400d and the auxiliary energy consumption branch 500b are added in the embodiment.

The bus fault protection branch 400d includes the second fast mechanical switch 410d and the one-way conduction switch 420d which are connected in series; the second fast mechanical switch 410d is connected to the second common bus; the one-way conduction switch 420d is connected to the first common bus; the intermediate point of the bus fault protection branch 400d is connected to the direct current bus; and the conduction direction of the one-way conduction switch 420d is the direction that the direct current bus points to the first common bus. The auxiliary energy consumption branch 500b includes the diode 510b and the linear resistor 520b which are connected in series.

One end of the auxiliary energy consumption branch 500b is connected to the first common bus, and the other end of the auxiliary energy consumption branch is connected to the ground or the metal loop; and the anode of the diode 510b points to the first common bus. In addition, the current breaking directions of the one-way commutation switches 121-12n of the through-flow branches 101-10n point to the ports. According to the embodiment, the working modes of the multi-port hybrid direct current circuit breaker include the normal operation mode, the opening mode, the closing mode and a bus fault protection mode.

When the multi-port hybrid direct current circuit breaker is in the normal operation mode, the first fast mechanical switches 111-11n and the one-way commutation switches 121-12n of the through-flow branches 101-10n are in an on state, the one-way breaking switch 310 of the breaking branch 300 is in an off state, and the second fast mechanical switch 410d and the one-way conduction switch 420d of the bus fault protection branch 400d are in an off state.

When the multi-port hybrid direct current circuit breaker is in the opening mode, and the Pₖ^{th} port connected to the multi-port hybrid direct current circuit breaker needs to be cut off, the action process is as follows.

Step I: Control the one-way breaking switch 310 of the breaking branch 300 to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switch 11k of the through-flow branch 10k of the Pₖ^{th} port to be opened when the current of all the through-flow branches 101-10n is close to zero.

Step III: Control the one-way breaking switch 310 of the breaking branch 300 to be off, and control the one-way commutation switches 121-12n of all the through-flow branches to be on when the first fast mechanical switch 11k of the through-flow branch 10k of the Pₖ^{th} port is opened to the insulation voltage position, transfer the current of the Pₖ^{th} port to the nonlinear resistor 320 of the breaking branch 300 and the linear resistor 520b of the auxiliary energy consumption branch 500b and gradually reduce the current to zero, recover the current of other ports which are not the Pₖ^{th} port to related through-flow branches, successfully open, and finish the opening operation.

When the multi-port hybrid direct current circuit breaker is in the closing mode and the Pₖ^{th} port connected to the multi-port hybrid direct current circuit breaker needs to be connected, the action process is as follows.

Step I: Control the one-way breaking switch 310 of the breaking branch 300 to be on.

Step II: Control the first fast mechanical switch 11k of the through-flow branch 10k of the Pₖ^{th} port to be on if the multi-port hybrid direct current circuit breaker is not closed due to a fault; and control the one-way breaking switch 310 of the breaking branch 300 to be off if the multi-port hybrid direct current circuit breaker is closed due to a fault, unsuccessfully close, and finish the closing operation.

Step III: Control the one-way breaking switch 310 of the breaking branch 300 to be off when the first fast mechanical switch 11k of the through-flow branch 10k of the Pₖ^{th} port is in a closing position, successfully close, and finish the closing operation.

When the multi-port hybrid direct current circuit breaker is in the bus fault protection mode and the direct current bus has a grounding fault, the action process is as follows.

Step I: Control the one-way breaking switch 310 of the breaking branch 300 to be on, control the one-way conduction switch 420d of the bus fault protection branch 400d to be on, control the one-way commutation switches 121-12n of all the through-flow branches 101-10n to be off, and start to transfer current to the one-way breaking switch 310 of the breaking branch 300 through the reversing branches 201-20n.

Step II: Control the first fast mechanical switches 111-11n of all the through-flow branches 101-10n to be opened when the current of all the through-flow branches 101-10n is close to zero.

Step III: Control the one-way breaking switch 310 of the breaking branch 300 to be off, and control the one-way commutation switches 121-12n of all the through-flow branches 101-10n to be on when the first fast mechanical switches 111-11n of all the through-flow branches 101-10n are opened to the insulation voltage position, transfer the current to the nonlinear resistor 320 of the breaking branch 300 and reduce the current to zero, successfully open, and finish the opening operation.

The multi-port hybrid direct current circuit breaker is in the bus fault protection mode, and when the first common bus has a grounding fault, bus differential protection of the multi-port hybrid direct current circuit breaker in the normal operation mode cannot act; and if the opening operation is carried out at the moment, the bus differential protection will act, and the direct current circuit breaker can stop the opening operation and start backup failure protection.

The multi-port hybrid direct current circuit breaker is in the bus fault protection mode, and when the second common bus has a grounding fault, the multi-port hybrid direct current circuit breaker cannot implement the bus isolation operation, so the second fast mechanical switch 410d of the bus fault protection branch 400d is controlled to be on to start the backup failure protection.

As shown in FIG. 1 to FIG. 11, the first fast mechanical switches 111-11n include at least one mechanical switch break connected in series; and the diode groups 211-21n, 221-22n and 510 include at least one diode connected in series. The one-way commutation switches 121-12n include at least one first switch semiconductor device connected in series; the one-way breaking switch 310 includes at least one second switch semiconductor device connected in series; and the first switch semiconductor device and the second switch semiconductor device may correspondingly include one or combination of IGBT, IEGT, IGCT and MOSFET.

It is to be noted that the first switch semiconductor device is a series component applied to the one-way commutation switch and the one-way breaking switch; the second switch semiconductor device is a series component applied to the one-way conduction switches, namely the switch semiconductor devices; the number and the distribution position of the switch semiconductor devices are determined according to an actual circuit structure; and the first switch semiconductor device and the second switch semiconductor device are general, are not limited in number and position, and only indicate different types of switch semiconductor devices.

First diodes and second diodes are only limited in distribution positions, are not limited in types and numbers, and are actually diodes.

The one-way conduction switch 420d or 420c includes at least one diode connected in series and at least one third switch semiconductor device connected in series; and the diode and the third switch semiconductor device are connected in series. The third switch semiconductor device includes one or a combination of SCR, IGBT, IEGT, IGCT and MOSFET. In addition, nonlinear resistance engineering is usually realized by a lightning arrester.

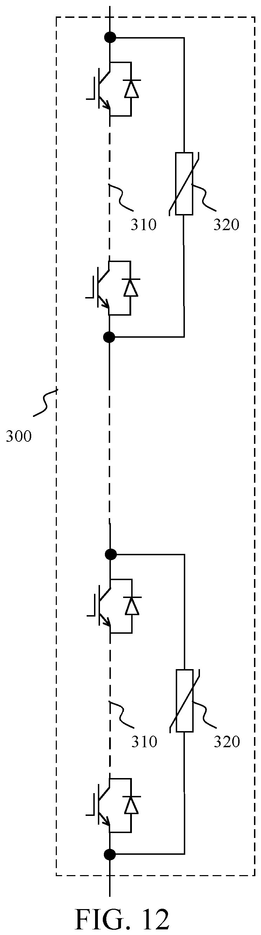

FIG. 12 is a schematic diagram of a breaking switch of a multi-port hybrid direct current circuit breaker according to an embodiment of this application. In the embodiment, the breaking switch may include a plurality of one-way breaking switches 310 connected in series and the nonlinear resistor 320 connected to the plurality of one-way breaking switches 310 in parallel.

In another aspect, the embodiment of this application further provides a fault protection apparatus for a direct current power grid system applying the above method, and the fault protection apparatus includes the multi-port hybrid direct current circuit breaker.

In yet another aspect, the embodiment of this application further provides a direct current power grid system applying the above method, and the direct current power grid system includes the above fault protection apparatus.

Technical characteristics of the abovementioned embodiments may be randomly combined. To make description concise, not all possible combinations of the technical characteristics in the abovementioned embodiments are described. However, the combinations of these technical characteristics shall be considered as falling within the scope recorded by this specification provided that no conflict exists.

The above embodiments only express several implementation modes of this application, and their descriptions are more specific and detailed, but cannot be understood as limiting the scope of the present invention patent. Therefore, the scope of protection of the present invention patent should be based on the attached claims.

## Claims

1. A multi-port hybrid direct current circuit breaker, comprising:
at least two through-flow branches (101, 10k, 10n), each of the at least two through-flow branches comprising a first mechanical switch (111, 11k, 11n) and a one-way commutation switch (121, 12k, 12n) which are connected in series, one ends of the at least two through-flow branches being connected with each other to form a direct current bus, and the current breaking directions of each of the one-way commutation switches of the at least two through-flow branches being the same;
at least two reversing branches (201, 20k, 20n), each of the at least two reversing branches comprising a diode upper bridge arm (211, 21k, 21n) and a diode lower bridge arm (221, 22k, 22n) which are connected in series in the same direction, and another ends of the at least two through-flow branches being correspondingly connected to intermediate points between the diode upper bridge arms and the diode lower bridge arms of the corresponding reversing branches to form ports (P1, Pk, Pn);
a breaking branch (300) comprising a one-way breaking switch (310) and a nonlinear resistor (320) which are connected in parallel, the breaking branch and the at least two reversing branches being connected with each other in parallel, a first common bus and a second common bus being formed at two ends subjected to parallel connections respectively, a current breaking direction of the one-way breaking switch of the breaking branch being the direction that the first common bus points to the second common bus, cathodes of the diode upper bridge arms of the at least two reversing branches being connected to the first common bus, and anodes of the diode lower bridge arms of the reversing branches being connected to the second common bus; and
a bus fault protection branch (400a, 400b, 400c, 400d) comprising a second mechanical switch (410a, 410b, 410c, 410d), wherein
one end of the second mechanical switch is connected to the direct current bus, and another end of the second mechanical switch is connected to the first common bus; or
one end of the second mechanical switch is connected to the direct current bus, and another end of the second mechanical switch is connected to the second common bus.

2. The multi-port hybrid direct current circuit breaker according to claim 1, wherein
the bus fault protection branch comprises the second mechanical switch and a one-way conduction switch (420c, 420d) which are connected in series, two ends of the bus fault protection branch being respectively connected to the first common bus and the second common bus, and an intermediate point between the second mechanical switch and the one-way conduction switch of the bus fault protection branch being connected to the direct current bus, wherein
in a case that one end of the second mechanical switch is connected to the first common bus, one end of the one-way conduction switch is connected to the second common bus; a conduction direction of the one-way conduction switch is a direction that the second common bus points to the direct current bus, and the current breaking directions of the one-way commutation switches of the through-flow branches are directions pointing to the direct current bus; or
in a case that one end of the second mechanical switch is connected to the second common bus, one end of the one-way conduction switch is connected to the first common bus; the conduction direction of the one-way conduction switch is a direction that the direct current bus points to the first common bus; and the current breaking directions of the one-way commutation switches of the through-flow branches are directions pointing to the ports.

3. The multi-port hybrid direct current circuit breaker according to claim 2, wherein
the one-way conduction switch comprises at least two diodes (421, 422) connected in series, and at least one third switch semiconductor device connected in series, and the at least one diode and the at least one third switch semiconductor device are connected in series; and
the third switch semiconductor device comprises at least one of SCR, IGBT, IEGT, IGCT or MOSFET.

4. The multi-port hybrid direct current circuit breaker according to any one of claims 1 to 3, further comprising:
an auxiliary energy consumption branch (500a, 500b) comprising a diode group (510a, 510b) and a linear resistor (520a, 520b) which are connected in series, wherein
in a case that one end of the second mechanical switch is connected to the direct current bus, and another end of the second mechanical switch is connected to the first common bus, one end of the auxiliary energy consumption branch is connected to the second common bus, and another end of the auxiliary energy consumption branch is connected to the ground or a metal loop; a cathode of the diode group is connected to the second common bus; or
in a case that one end of the second mechanical switch is connected to the direct current bus, and another end of the second mechanical switch is connected to the second common bus, one end of the auxiliary energy consumption branch is connected to the first common bus, and another end of the auxiliary energy consumption branch is connected to the ground or the metal loop; and
an anode of the diode group is connected to the first common bus; wherein the diode group comprises at least one diode connected in series.

5. The multi-port hybrid direct current circuit breaker according to any one of claims 1 to 4, wherein
the first mechanical switch comprises at least two mechanical switch breaks connected in series; and/or
the second mechanical switch comprises at least two mechanical switch breaks connected in series; and/or
the one-way commutation switch comprises at least two first switch semiconductor devices connected in series; and/or
the one-way breaking switch comprises at least two second switch semiconductor devices connected in series; and/or
the first switch semiconductor device and the second switch semiconductor device comprise at least one of IGBT, IEGT, IGCT or MOSFET.

6. The multi-port hybrid direct current circuit breaker according to claim 1, wherein
the diode upper bridge arm comprises at least two diodes connected in series; and
the diode lower bridge arm comprises at least two diodes connected in series.

7. A control method of the multi-port hybrid direct current circuit breaker according to any one of claims 1 to 6, comprising:
in a case that the multi-port hybrid direct current circuit breaker is in a bus fault protection mode and the direct current bus has a grounding fault:
controlling the one-way breaking switch of the breaking branch to be on, controlling the one-way conduction switch of the bus fault protection branch to be on, controlling the one-way commutation switches of all the through-flow branches to be off;
controlling the first mechanical switches of all the through-flow branches to be opened when the current of all the through-flow branches is close to zero; and
controlling the one-way breaking switch of the breaking branch to be off, and controlling the one-way commutation switches of all the through-flow branches to be on when the first mechanical switches of all the through-flow branches are opened.

8. The method according to claim 7, wherein the method further comprises:
in a case that the multi-port hybrid direct current circuit breaker is in a normal operation mode:
controlling each through-flow branch to be in an on state, and controlling the breaking branch to be in an off state; and
controlling the bus fault protection branch to be in an off state in a case that the multi-port hybrid direct current circuit breaker is in the normal operation mode.

9. The method according to claims 7 to 8, wherein the method further comprises:
in a case that the multi-port hybrid direct current circuit breaker is in an opening mode and the port connected to the multi-port hybrid direct current circuit breaker needs to be cut off:
controlling the one-way breaking switch of the breaking branch to be on, and controlling the one-way commutation switches of all the through-flow branches to be off, and starting to transfer current to the one-way breaking switch of the breaking branch through the reversing branches;
controlling the first mechanical switch of the through-flow branch in which the port to be cut off is located to be opened in a case that the current of all the through-flow branches is close to zero; and
controlling the one-way breaking switch of the breaking branch to be off, and controlling the one-way commutation switches of all the through-flow branches to be on in a case that the first mechanical switch of the through-flow branch in which the port to be cut off is located is opened to an insulation voltage position, and controlling the current of the port to be cut off to be transferred to the nonlinear resistor of the breaking branch and the linear resistor of the auxiliary energy consumption branch; and recovering the current of other ports except the port to be cut off to related through-flow branches in a case that the current of the port to be cut off is gradually reduced to zero, successfully opening, and finishing a opening operation.

10. The control method according to claims 7 to 9, wherein the method further comprises:
in a case that the multi-port hybrid direct current circuit breaker is in a closing mode and the port connected to the multi-port hybrid direct current circuit breaker needs to be connected:
controlling the one-way breaking switch of the breaking branch to be on;
controlling the first mechanical switch of the through-flow branch in which the port to be connected is located to be on in a case that the multi-port hybrid direct current circuit breaker is not closed due to a fault;
controlling the one-way breaking switch of the breaking branch to be off in a case that the first mechanical switch of the through-flow branch in which the port to be connected is located is in a closed position, successfully closing, and finishing closing operation; and
controlling the one-way breaking switch of the breaking branch to be off in a case that the multi-port hybrid direct current circuit breaker is closed due to a fault, failing closing, and finishing the closing operation.

11. The control method according to claim 7, wherein
in a case that the fault type is that the multi-port hybrid direct current circuit breaker is connected to a positive electrode of a direct current power grid system and the first common bus has a grounding fault, the multi-port hybrid direct current circuit breaker is not capable of implementing a bus isolation operation, and the second mechanical switch of the bus fault protection branch is controlled to be on to start a backup failure protection;
in a case that the fault type is that the multi-port hybrid direct current circuit breaker is connected to a negative electrode of the direct current power grid system and the second common bus has a grounding fault, the multi-port hybrid direct current circuit breaker is not capable of implementing the bus isolation operation, and the second mechanical switch of the bus fault protection branch is controlled to be on to start the backup failure protection;
in a case that the fault type is that the multi-port hybrid direct current circuit breaker is connected to the positive electrode of the direct current power grid system and the second common bus has a grounding fault, bus differential protection of the multi-port hybrid direct current circuit breaker in the normal operation mode is not capable of acting, and in a case that the opening operation is carried out at the moment, the bus differential protection are triggered, and the opening operation is stopped by the multi-port hybrid direct current circuit breaker and the backup failure protection are started; and/or
in a case that the fault type is that the multi-port hybrid direct current circuit breaker is connected to the negative electrode of the direct current power grid system and the first common bus has a grounding fault, the bus differential protection of the multi-port hybrid direct current circuit breaker in the normal operation mode is not capable of acting, and in a case that the opening operation is carried out at the moment, the bus differential protection are triggered, and the opening operation is stopped by the multi-port hybrid direct current circuit breaker and the backup failure protection are started.

12. A fault protection apparatus of a direct current power grid system, comprising the multi-port hybrid direct current circuit breaker according to any one of claims 1 to 11.

13. A direct current power grid system, comprising the fault protection apparatus according to claim 12.

## Patentansprüche

1. Hybrider Gleichstrom-Unterbrecher mit mehreren Anschlüssen, der umfasst:
wenigstens zwei Durchfluss-Zweige (101, 10k, 10n), wobei jeder der wenigstens zwei Durchfluss-Zweige einen ersten mechanischen Schalter (111, 11k, 11n) sowie einen Einweg-Umschalter (121, 12k, 12n) umfasst, die in Reihe verbunden sind, wobei die einen Enden der wenigstens zwei Durchfluss-Zweige so miteinander verbunden sind, dass sie einen Gleichstrombus bilden, und die Stromunterbrechungsrichtungen jedes der Einweg-Umschalter der wenigstens zwei Durchfluss-Zweige die gleichen sind;
wenigstens zwei Umkehr-Zweige (201, 20k, 20n), wobei jeder der wenigstens zwei Umkehr-Zweige einen oberen Diodenbrücken-Arm (211, 21k, 21n) sowie einen unteren Diodenbrücken-Arm (221, 22k, 22n) umfasst, die in Reihe in der gleichen Richtung verbunden sind und die anderen Enden der wenigstens zwei Durchfluss-Zweige entsprechend mit Punkten zwischen den oberen Diodenbrücken-Armen und den unteren Diodenbrücken-Armen der entsprechenden Umkehr-Zweige verbunden sind und Anschlüsse (P1, Pk, Pn) bilden;
einen Unterbrechungs-Zweig (300), der einen Einweg-Unterbrechungsschalter (310) sowie einen nichtlinearen Widerstand (320) umfasst, die parallel verbunden sind, wobei der Unterbrechungsschalter und die wenigstens zwei Umkehr-Zweige parallel miteinander verbunden sind, ein erster gemeinsamer Bus sowie ein zweiter gemeinsamer Bus an zwei Enden gebildet werden, die jeweils Parallelverbindungen aufweisen, eine Stromunterbrechungsrichtung des Einweg-Unterbrechungsschalters des Unterbrechungs-Zweiges die Richtung ist, in der der erste gemeinsame Bus zu dem zweiten gemeinsamen Bus weist, Kathoden der oberen Diodenbrücken-Arme der wenigstens zwei Umkehr-Zweige mit dem ersten gemeinsamen Bus verbunden sind und Anoden der unteren Diodenbrücken-Arme der Umkehr-Zweige mit dem zweiten gemeinsamen Bus verbunden sind; sowie
einen Busfehlerschutz-Zweig (400a, 400b, 400c, 400d), der einen zweiten mechanischen Schalter (410a, 410b, 410c, 410d) umfasst, wobei
ein Ende des zweiten mechanischen Schalters mit dem Gleichstrombus verbunden ist und ein anderes Ende des zweiten mechanischen Schalters mit dem ersten gemeinsamen Bus verbunden ist; oder
ein Ende des zweiten mechanischen Schalters mit dem Gleichstrombus verbunden ist und ein anderes Ende des zweiten mechanischen Schalters mit dem zweiten gemeinsamen Bus verbunden ist.

2. Hybrider Gleichstrom-Unterbrecher mit mehreren Anschlüssen nach Anspruch 1, wobei der Busfehlerschutz-Zweig den zweiten mechanischen Schalter sowie einen Einweg-Leitungsschalter (420c, 420d) umfasst, die in Reihe verbunden sind, wobei zwei Enden des Busfehlerschutz-Zweiges mit dem ersten gemeinsamen Bus bzw. dem zweiten gemeinsamen Bus verbunden sind und ein Punkt zwischen dem zweiten mechanischen Schalter und dem Einweg-Leitungsschalter des Busfehlerschutz-Zweiges mit dem Gleichstrombus verbunden ist, wobei
wenn ein Ende des zweiten mechanischen Schalters mit dem ersten gemeinsamen Bus verbunden ist und ein Ende des Einweg-Leitungsschalters mit dem zweiten gemeinsamen Bus verbunden ist, eine Leitungsrichtung des Einweg-Leitungsschalters eine Richtung ist, in der der zweite gemeinsame Bus zu dem Gleichstrombus weist, und die Stromunterbrechungsrichtungen der Einweg-Umschalter der Durchfluss-Zweige zu dem Gleichstrombus weisende Richtungen sind; oder
wenn ein Ende des zweiten mechanischen Schalters mit dem zweiten gemeinsamen Bus verbunden ist und ein Ende des Einweg-Leitungsschalters mit dem ersten gemeinsamen Bus verbunden ist, die Leitungsrichtung des Einweg-Leitungsschalters eine Richtung ist, in der der Gleichstrombus zu dem ersten gemeinsamen Bus weist, und die Stromunterbrechungsrichtungen der Einweg-Umschalter der Durchfluss-Zweige zu den Anschlüssen weisende Richtungen sind.

3. Hybrider Gleichstrom-Unterbrecher mit mehreren Anschlüssen nach Anspruch 2, wobei der Einweg-Leitungsschalter wenigstens zwei in Reihe verbundene Dioden (421, 422) sowie wenigstens eine dritte in Reihe verbundene Halbleiter-Schaltereinrichtung umfasst und die wenigstens eine Diode und die wenigstens eine dritte Halbleiter-Schaltereinrichtung in Reihe verbunden sind; und
die dritte Halbleiter-Schaltereinrichtung einen SCR, IGBT, IEGT, IGCT oder/und einen MOSFET umfasst.

4. Hybrider Gleichstrom-Unterbrecher mit mehreren Anschlüssen nach einem der Ansprüche 1 bis 3, der des Weiteren umfasst:
einen zusätzlichen Energieverbrauchs-Zweig (500a, 500b), der eine Diodengruppe (510a, 510b) sowie einen linearen Widerstand (520a, 520b) umfasst, die in Reihe verbunden sind, wobei
wenn ein Ende des zweiten mechanischen Schalters mit dem Gleichstrombus verbunden ist und ein anderes Ende des zweiten mechanischen Schalters mit dem ersten gemeinsamen Bus verbunden ist, ein Ende des zusätzlichen Energieverbrauchs-Zweiges mit dem zweiten gemeinsamen Bus verbunden ist und ein anderes Ende des zusätzlichen Energieverbrauchs-Zweiges mit der Erde oder einer Metallschleife verbunden ist, eine Kathode der Diodengruppe mit dem zweiten gemeinsamen Bus verbunden ist; oder
wenn ein Ende des zweiten mechanischen Schalters mit dem Gleichstrombus verbunden ist und ein anderes Ende des zweiten mechanischen Schalters mit dem zweiten gemeinsamen Bus verbunden ist, ein Ende des zusätzlichen Energieverbrauchs-Zweiges mit dem ersten gemeinsamen Bus verbunden ist und ein anderes Ende des zusätzlichen Energieverbrauchs-Zweiges mit der Erde oder der Metallschleife verbunden ist; und
eine Anode der Diodengruppe mit dem ersten gemeinsamen Bus verbunden ist, wobei die Diodengruppe wenigstens eine in Reihe verbundene Diode umfasst.

5. Hybrider Gleichstrom-Unterbrecher mit mehreren Anschlüssen nach einem der Ansprüche 1 bis 4, wobei
der erste mechanische Schalter wenigstens zwei in Reihe verbundene mechanische Schaltunterbrecher umfasst; und/oder
der zweite mechanische Schalter wenigstens zwei in Reihe verbundene mechanische Schaltunterbrecher umfasst; und/oder
der Einweg-Umschalter wenigstens zwei erste in Reihe verbundene Halbleiter-Schaltereinrichtungen umfasst; und/oder
der Einweg-Unterbrechungsschalter wenigstens zwei zweite in Reihe verbundene Halbleiter-Schaltereinrichtungen umfasst; und/oder
die erste Halbleiter-Schaltereinrichtung und die zweite Halbleiter- Schaltereinrichtung einen IGBT, IEGT, IGCT oder/und einen MOSFET umfassen.

6. Hybrider Gleichstrom-Unterbrecher mit mehreren Anschlüssen nach Anspruch 1, wobei der obere Diodenbrücken-Arm wenigstens zwei in Reihe verbundene Dioden umfasst; und der untere Diodenbrücken-Arm wenigstens zwei in Reihe verbundene Dioden umfasst.

7. Verfahren zum Steuern des hybriden Gleichstrom-Unterbrechers mit mehreren Anschlüssen nach einem der Ansprüche 1 bis 6, das umfasst:
wenn sich der hybride Gleichstrom-Unterbrecher mit mehreren Anschlüssen in einem Busfehlerschutz-Modus befindet und der Gleichstrombus einen Erdschluss aufweist:
Steuern des Einweg-Unterbrechungsschalters des Unterbrechungs-Zweiges, so dass er angeschaltet ist, Steuern des Einweg-Leitungsschalters des Busfehlerschutz--Zweiges, so dass er angeschaltet ist, Steuern der Einweg-Umschalter aller Durchfluss-Zweige, so dass sie abgeschaltet sind;
Steuern der ersten mechanischen Schalter aller Durchfluss-Zweige, so dass sie geöffnet sind, wenn der Strom aller Durchfluss-Zweige nahe Null liegt; und
Steuern des Einweg-Unterbrechungsschalters des Unterbrechungs-Zweiges, so dass er abgeschaltet ist, sowie Steuern der Einweg-Umschalter aller Durchfluss-Zweige, so dass sie angeschaltet sind, wenn die ersten mechanischen Schalter aller Durchfluss-Zweige geöffnet sind.

8. Verfahren nach Anspruch 7, wobei das Verfahren des Weiteren umfasst:
wenn sich der hybride Gleichstrom-Unterbrecher mit mehreren Anschlüssen in einem normalen Betriebsmodus befindet:
Steuern jedes Durchfluss-Zweiges, sodass er sich in einem angeschalteten Zustand befindet, und Steuern des Unterbrechungs-Zweiges, so dass er sich in einem abgeschalteten Zustand befindet; sowie
Steuern des Busfehlerschutz-Zweiges, so dass er sich in einem abgeschalteten Zustand befindet, wenn sich der hybride Gleichstrom-Unterbrecher mit mehreren Anschlüssen in dem normalen Betriebsmodus befindet.

9. Verfahren nach Anspruch 7oder 8, wobei das Verfahren des Weiteren umfasst:
wenn sich der hybride Gleichstrom-Unterbrecher mit mehreren Anschlüssen in einem Öffnungs-Modus befindet und der mit dem mehrpoligen hybriden Gleichstrom-Unterbrecher verbundene Anschluss getrennt werden muss:
Steuern des Einweg-Unterbrechungsschalters des Unterbrechungs-Zweiges, so dass er angeschaltet ist, und Steuern der Einweg-Umschalter aller Durchfluss-Zweige, so dass sie abgeschaltet sind, sowie Beginnen damit, Strom über die Umkehr-Zweige zu dem Einweg-Unterbrechungsschalter des Unterbrechungs-Zweiges zu übertragen;
Steuern des ersten mechanischen Schalters des Durchfluss-Zweiges, in dem sich der zu trennende Anschluss befindet, so dass er geöffnet wird, wenn der Strom aller Durchfluss-Zweige nahe Null liegt; und
Steuern des Einweg-Unterbrechungsschalters des Unterbrechungs-Zweiges, so dass er abgeschaltet ist, sowie Steuern der Einweg-Umkehrschalter aller Durchfluss-Zweige, so dass sie angeschaltet sind, wenn der erste mechanische Schalter des Durchfluss-Zweiges, in dem sich der zu trennende Anschluss befindet, an eine Isolationsspannungs-Position geöffnet wird, und Steuern des Stroms des Anschlusses, so dass Übertragung zu dem nichtlinearen Widerstand des Unterbrechungs-Zweiges und dem linearen Widerstand des zusätzlichen Energieverbrauchs-Zweiges unterbrochen wird, sowie Regenerieren des Stroms anderer Anschlüsse mit Ausnahme des zu trennenden Anschlusses zu zugehörigen Durchfluss-Zweigen, wenn der Strom des zu trennenden Anschlusses allmählich auf Null reduziert wird, erfolgreiches Öffnen und Abschließen eines Öffnungsvorgangs.

10. Steuerungsverfahren nach den Ansprüchen 7 bis 9, wobei das Verfahren des Weiteren umfasst:
wenn sich der hybride Gleichstrom-Unterbrecher mit mehreren Anschlüssen in einem Schließ-Modus befindet und der mit dem hybriden Gleichstrom-Unterbrecher mit mehreren Anschlüssen verbundene Anschluss verbunden werden muss:
Steuern des Einweg-Unterbrechungsschalters des Unterbrechungs-Zweiges, so dass er angeschaltet ist;
Steuern des ersten mechanischen Schalters des Durchfluss-Zweiges, in dem sich der zu verbindende Anschluss befindet, sodass er angeschaltet ist, wenn der hybride Gleichstrom-Unterbrecher mit mehreren Anschlüssen aufgrund eines Fehlers nicht geschlossen wird;
Steuern des Einweg-Unterbrechungsschalters des Unterbrechungs-Zweiges, so dass er abgeschaltet ist, wenn der erste mechanische Schalter des Durchfluss-Zweiges, in dem sich der zu verbindende Anschluss befindet, sich in einer geschlossenen Position befindet, erfolgreiches Schließen und Abschließen des Schließvorgangs; sowie
Steuern des Einweg-Unterbrechungsschalters Als Unterbrechungs-Zweiges, so dass er abgeschaltet ist, wenn der hybride Gleichstrom-Unterbrecher mit mehreren Anschlüssen aufgrund eines Fehlers geschlossen wird, nicht erfolgreiches Schließen und Abschließen des Schließvorgangs.

11. Steuerungsverfahren nach Anspruch 7, wobei
wenn der Typ des Fehlers darin besteht, dass der hybride Gleichstrom-Unterbrecher mit mehreren Anschlüssen mit einer positiven Elektrode eines Gleichstrom-Versorgungsnetzsystems verbunden ist und der erste gemeinsame Bus einen Erdschluss aufweist, der hybride Gleichstrom-Unterbrecher mit mehreren Anschlüssen nicht in der Lage ist, einen Bus-Isolationsvorgang zu implementieren, und der zweite mechanische Schalter des Busfehlerschutz-Zweiges so gesteuert wird, dass er angeschaltet ist, um einen Backup-Fehlerschutz in Gang zu setzen;
wenn der Typ des Fehlers darin besteht, dass der hybride Gleichstrom-Unterbrecher mit mehreren Anschlüssen mit einer negativen Elektrode eines Gleichstrom-Versorgungsnetzsystems verbunden ist und der zweite gemeinsame Bus einen Erdschluss aufweist, der hybride Gleichstrom-Unterbrecher mit mehreren Anschlüssen nicht in der Lage ist, den Bus-Isolationsvorgang zu implementieren, und der zweite mechanische Schalter des Busfehlerschutz-Zweiges so gesteuert wird, dass er angeschaltet ist, um einen Backup-Fehlerschutz in Gang zu setzen;
wenn der Typ des Fehlers darin besteht, dass der hybride Gleichstrom-Unterbrecher mit mehreren Anschlüssen mit der positiven Elektrode des Gleichstrom-Versorgungsnetzsystems verbunden ist und der zweite gemeinsame Bus einen Erdschluss aufweist, Bus-Differentialschutz des hybriden Gleichstrom-Unterbrechers mit mehreren Anschlüssen in dem normalen Betriebsmodus nicht in der Lage ist, zu wirken, und wenn der Öffnungsvorgang in diesem Moment ausgeführt wird, der Bus-Differentialschutz ausgelöst wird, und der Öffnungsvorgang durch den hybriden Gleichstrom-Unterbrecher mit mehreren Anschlüssen unterbrochen wird und der Backup-Fehlerschutz in Gang gesetzt wird; und/oder
wenn der Typ des Fehlers darin besteht, dass der hybride Gleichstrom-Unterbrecher mit mehreren Anschlüssen mit der negativen Elektrode des Gleichstrom-Versorgungsnetzsystems verbunden ist und der erste gemeinsame Bus einen Erdschluss aufweist, der Bus-Differentialschutz des mehrpoligen hybriden Gleichstrom-Unterbrechers mit mehreren Anschlüssen in dem normalen Betriebsmodus nicht in der Lage ist, zu wirken, und wenn der Öffnungsvorgang in diesem Moment ausgeführt wird, der Bus-Differentialschutz ausgelöst wird, und der Öffnungsvorgang durch den hybriden Gleichstrom-Unterbrecher mit mehreren Anschlüssen unterbrochen wird und der Backup-Fehlerschutz in Gang gesetzt wird.

12. Fehlerschutzvorrichtung eines Gleichstrom-Versorgungsnetzsystems, das den hybriden Gleichstrom-Unterbrecher mit mehreren Anschlüssen nach einem der Ansprüche 1 bis 11 umfasst.

13. Gleichstrom-Versorgungsnetzsystem, das die Fehlerschutzvorrichtung nach Anspruch 12 umfasst.

## Revendications

1. Disjoncteur hybride multiport pour courant continu, comprenant :
au moins deux branches de courant traversant (101, 10k, 10n), chacune desdites au moins deux branches de courant traversant comprenant un premier interrupteur mécanique (111, 11k, 11n) et un interrupteur de commutation unidirectionnel (121, 12k, 12n) qui sont connectés en série, les extrémités desdites au moins deux branches de courant traversant étant connectée entre elles pour former un bus de courant continu, et les directions de coupure de courant de chacun des interrupteurs de commutation unidirectionnels desdites au moins deux branches de courant traversant étant identiques ;
au moins deux branches d'inversion (201, 20k, 20n), chacune desdites au moins deux branches d'inversion comprenant un bras de pont supérieur à diode (211, 21k, 21n) et un bras de pont inférieur à diode (221, 22k, 22n) qui sont connectés en série dans la même direction, et les autres extrémités desdites au moins deux branches de courant traversant étant connectées de manière correspondante à des points intermédiaires entre les bras de pont supérieur à diode et les bras de pont inférieur à diode des branches d'inversion correspondantes pour former des ports (P1, Pk, Pn) ;
une branche de coupure (300) comprenant un interrupteur de coupure unidirectionnel (310) et une résistance non linéaire (320) connectés en parallèle, la branche de coupure et lesdites au moins deux branches d'inversion étant connectées entre elles en parallèle, un premier bus commun et un deuxième bus commun étant formés à deux extrémités soumises respectivement à des connexions parallèles, la direction de coupure de courant de l'interrupteur de coupure unidirectionnel de la branche de coupure étant la direction dans laquelle pointe le premier bus commun vers le deuxième bus commun, les cathodes des bras de pont supérieur à diode desdites au moins deux branches d'inversion étant connectées au premier bus commun, et les anodes des bras de pont inférieur à diode des branches d'inversion étant connectées au deuxième bus commun ; et
une branche de protection contre les défauts de bus (400a, 400b, 400c, 400d) comprenant un deuxième interrupteur mécanique (410a, 410b, 410c, 410d), dans lequel
une extrémité du deuxième interrupteur mécanique est connectée au bus de courant continu, et une autre extrémité du deuxième interrupteur mécanique est connectée au premier bus commun ; ou
une extrémité du deuxième interrupteur mécanique est connectée au bus de courant continu, et l'autre extrémité du deuxième interrupteur mécanique est connectée au deuxième bus commun.

2. Disjoncteur hybride multiport pour courant continu selon la revendication 1, dans lequel
la branche de protection contre les défauts de bus comprend le deuxième interrupteur mécanique et un interrupteur de conduction unidirectionnel (420c, 420d) qui sont connectés en série, deux extrémités de la branche de protection contre les défauts de bus étant connectées respectivement au premier bus commun et au deuxième bus commun, et un point intermédiaire entre le deuxième interrupteur mécanique et l'interrupteur de conduction unidirectionnel de la branche de protection contre les défauts de bus étant connecté au bus de courant continu, dans lequel
dans le cas où une extrémité du deuxième interrupteur mécanique est connectée au premier bus commun, une extrémité de l'interrupteur de conduction unidirectionnel est connectée au deuxième bus commun, une direction de conduction de l'interrupteur de conduction unidirectionnel est une direction dans laquelle pointe le deuxième bus commun vers le bus de courant continu, et les directions de coupure de courant des interrupteurs de commutation unidirectionnels des branches de courant traversant sont des directions pointant vers le bus de courant continu ; ou
dans le cas où une extrémité du deuxième interrupteur mécanique est connectée au deuxième bus commun, une extrémité de l'interrupteur de conduction unidirectionnel est connectée au premier bus commun ; la direction de conduction de l'interrupteur de conduction unidirectionnel est une direction dans laquelle pointe le bus de courant continu vers le premier bus commun ; et les directions de coupure de courant des interrupteurs de commutation unidirectionnels des branches de courant traversant sont des directions pointant vers les ports.

3. Disjoncteur hybride multiport pour courant continu selon la revendication 2, dans lequel
l'interrupteur de conduction unidirectionnel comprend au moins deux diodes (421, 422) connectées en série et au moins un troisième dispositif interrupteur semi-conducteur connecté en série, et ladite au moins une diode et ledit au moins un troisième dispositif interrupteur semi-conducteur sont connectés en série ; et
le troisième dispositif interrupteur semi-conducteur comprend au moins l'un des composants suivants : SCR, IGBT, IEGT, IGCT et MOSFET.

4. Disjoncteur hybride multiport pour courant continu selon l'une quelconque des revendications 1 à 3, comprenant en outre :
une branche de consommation d'énergie auxiliaire (500a, 500b) comprenant un groupe de diodes (510a, 510b) et une résistance linéaire (520a, 520b) qui sont connectés en série, dans lequel
dans le cas où une extrémité du deuxième interrupteur mécanique est connectée au bus de courant continu et une autre extrémité du deuxième interrupteur mécanique est connectée au premier bus commun, une extrémité de la branche de consommation d'énergie auxiliaire est connectée au deuxième bus commun, et une autre extrémité de la branche de consommation d'énergie auxiliaire est connectée à la terre ou à une boucle métallique ; une cathode du groupe de diodes est connectée au deuxième bus commun ; ou
dans le cas où une extrémité du deuxième interrupteur mécanique est connectée au bus de courant continu et une autre extrémité du deuxième interrupteur mécanique est connectée au deuxième bus commun, une extrémité de la branche de consommation d'énergie auxiliaire est connectée au premier bus commun, et une autre extrémité de la branche de consommation d'énergie auxiliaire est connectée à la terre ou à la boucle métallique ; et
une anode du groupe de diodes est connectée au premier bus commun ; dans lequel le groupe de diodes comprend au moins une diode connectée en série.

5. Disjoncteur hybride multiport pour courant continu selon l'une quelconque des revendications 1 à 4, dans lequel le premier interrupteur mécanique comprend au moins deux interrupteurs mécaniques connectés en série ; et/ou
le deuxième interrupteur mécanique comprend au moins deux interrupteurs mécaniques connectés en série ; et/ou
l'interrupteur de commutation unidirectionnel comprend au moins deux premiers dispositifs interrupteurs semi-conducteurs connectés en série ; et/ou
l'interrupteur de coupure unidirectionnel comprend au moins deux deuxièmes dispositifs interrupteurs semi-conducteurs connectés en série ; et/ou
le premier dispositif interrupteur semi-conducteur et le deuxième dispositif interrupteur semi-conducteur comprennent au moins l'un des composants suivants : IGBT, IEGT, IGCT et MOSFET.

6. Disjoncteur hybride multiport pour courant continu selon la revendication 1, dans lequel
le bras de pont supérieur à diode comprend au moins deux diodes connectées en série ; et
le bras de pont inférieur à diode comprend au moins deux diodes connectées en série.

7. Procédé de commande du disjoncteur hybride multiport pour courant continu selon l'une quelconque des revendications 1 à 6, comprenant :
dans le cas où le disjoncteur hybride multiport pour courant continu est en mode de protection contre les défauts de bus et où le bus de courant continu présente un défaut de mise à la terre :
la commande d'activation de l'interrupteur de coupure unidirectionnel de la branche de coupure, la commande d'activation de l'interrupteur de conduction unidirectionnel de la branche de protection contre les défauts de bus, la commande de désactivation des interrupteurs de commutation unidirectionnels de toutes les branches de courant traversant ;
la commande d'ouverture des premiers interrupteurs mécaniques de toutes les branches de courant traversant quand le courant de toutes les branches de courant traversant est proche de zéro ; et
la commande de désactivation de l'interrupteur de coupure unidirectionnel de la branche de coupure, et la commande d'activation des interrupteurs de commutation unidirectionnels de toutes les branches de courant traversant quand les premiers interrupteurs mécaniques de toutes les branches de courant traversant sont ouverts.

8. Procédé selon la revendication 7, dans lequel le procédé comprend en outre :
dans le cas où le disjoncteur hybride multiport pour courant continu est en mode de fonctionnement normal :
la commande de chaque branche de courant traversant pour qu'elle soit dans un état activé et la commande de la branche de coupure pour qu'elle soit dans un état désactivé ; et
la commande de la branche de protection contre les défauts de bus pour qu'elle soit dans un état désactivé dans le cas où le disjoncteur hybride multiport pour courant continu est en mode de fonctionnement normal.

9. Procédé selon les revendications 7 et 8, dans lequel le procédé comprend en outre :
dans le cas où le disjoncteur hybride multiport pour courant continu est en mode d'ouverture et où le port connecté au disjoncteur hybride multiport pour courant continu doit être coupé :
la commande d'activation de l'interrupteur de coupure unidirectionnel de la branche de coupure et la commande de désactivation des interrupteurs de commutation unidirectionnels de toutes les branches de courant traversant, et le démarrage du transfert de courant vers l'interrupteur de coupure unidirectionnel de la branche de coupure via les branches d'inversion ;
la commande de l'ouverture du premier interrupteur mécanique de la branche de courant traversant dans laquelle se trouve le port à couper dans le cas où le courant de toutes les branches de courant traversant est proche de zéro ; et
la commande de désactivation de l'interrupteur de coupure unidirectionnel de la branche de coupure, et la commande d'activation des interrupteurs de commutation unidirectionnels de toutes les branches de courant traversant dans le cas où le premier interrupteur mécanique de la branche de courant traversant dans laquelle se trouve le port à couper est ouvert à une position de tension d'isolement, et la commande de transfert du courant du port à couper à la résistance non linéaire de la branche de coupure et à la résistance linéaire de la branche de consommation d'énergie auxiliaire ; et la récupération du courant d'autres ports, à l'exception du port à couper, vers les branches de courant traversant associées dans le cas où le courant du port à couper est progressivement réduit à zéro, l'ouverture est effectuée avec succès et l'opération d'ouverture est finalisée.

10. Procédé de commande selon les revendications 7 à 9, dans lequel le procédé comprend en outre :
dans le cas où le disjoncteur hybride multiport pour courant continu est en mode de fermeture et où le port connecté au disjoncteur hybride multiport pour courant continu doit être connecté :
la commande d'activation de l'interrupteur de coupure unidirectionnel de la branche de coupure ;
la commande d'activation du premier interrupteur mécanique de la branche de courant traversant dans laquelle se trouve le port à connecter dans le cas où le disjoncteur hybride multiport pour courant continu n'est pas fermé en raison d'un défaut ;
la commande de désactivation de l'interrupteur de coupure unidirectionnel de la branche de coupure dans le cas où le premier interrupteur mécanique de la branche de courant traversant dans laquelle se trouve le port à connecter est en position fermée, la fermeture est effectuée avec succès et l'opération de fermeture est finalisée ; et
la commande de désactivation de l'interrupteur de coupure unidirectionnel de la branche de coupure dans le cas où le disjoncteur hybride multiport pour courant continu est fermé en raison d'un défaut, la fermeture est un échec et l'opération de fermeture est finalisée.

11. Procédé de commande selon la revendication 7, dans lequel
dans le cas où le type de défaut est que le disjoncteur hybride multiport pour courant continu est connecté à une électrode positive d'un système de réseau électrique à courant continu et où le premier bus commun présente un défaut de mise à la terre, le disjoncteur hybride multiport pour courant continu n'est pas capable de mettre en œuvre une opération d'isolation de bus, et le deuxième interrupteur mécanique de la branche de protection contre les défauts de bus est commandé pour être activé afin de démarrer une protection de secours contre les pannes ;
dans le cas où le type de défaut est que le disjoncteur hybride multiport pour courant continu est connecté à une électrode négative du système de réseau électrique à courant continu et où le deuxième bus commun présente un défaut de mise à la terre, le disjoncteur hybride multiport pour courant continu n'est pas capable de mettre en œuvre l'opération d'isolation de bus, et le deuxième interrupteur mécanique de la branche de protection contre les défauts de bus est commandé pour être activé afin de démarrer la protection de secours contre les pannes ;
dans le cas où le type de défaut est que le disjoncteur hybride multiport pour courant continu est connecté à l'électrode positive du système de réseau électrique à courant continu et où le deuxième bus commun présente un défaut de mise à la terre, la protection différentielle de bus du disjoncteur hybride multiport pour courant continu en mode de fonctionnement normal n'est pas capable d'agir, et dans le cas où l'opération d'ouverture est effectuée à ce moment-là, la protection différentielle de bus est déclenchée, et l'opération d'ouverture est arrêtée par le disjoncteur hybride multiport pour courant continu et la protection de secours contre les pannes est démarrée ; et/ou
dans le cas où le type de défaut est que le disjoncteur hybride multiport pour courant continu est connecté à l'électrode négative du système de réseau électrique à courant continu et où le premier bus commun présente un défaut de mise à la terre, la protection différentielle de bus du disjoncteur hybride multiport pour courant continu en mode de fonctionnement normal n'est pas capable d'agir, et dans le cas où l'opération d'ouverture est effectuée à ce moment-là, la protection différentielle de bus est déclenchée, et l'opération d'ouverture est arrêtée par le disjoncteur hybride multiport pour courant continu et la protection de secours contre les pannes est démarrée.

12. Appareil de protection contre les défauts d'un système de réseau électrique à courant continu, comprenant le disjoncteur hybride multiport pour courant continu selon l'une quelconque des revendications 1 à 11.

13. Système de réseau électrique à courant continu, comprenant l'appareil de protection contre les défauts selon la revendication 12.
